(19) Europäisches Patentamt
European Patent Office
Office européen des brevets

(11) **EP 2 046 100 B1**

(12) **EUROPEAN PATENT SPECIFICATION**

(45) Date of publication and mention
of the grant of the patent:
**18.08.2010 Bulletin 2010/33**

(51) Int Cl.:
***H05G 2/00*** (2006.01)

(21) Application number: **08017220.8**

(22) Date of filing: **30.09.2008**

(54) **A method for generating extreme ultraviolet radiation and an extreme ultraviolet light source device**

Verfahren zum Erzeugen extremer Ultraviolettstrahlung und Vorrichtung als Quelle für extremes Ultraviolettlicht

Procédé de génération de rayonnement d'ultraviolets extrêmes et dispositif de source lumineuse d'ultraviolets extrêmes

(84) Designated Contracting States:
**DE NL**

(30) Priority: **01.10.2007 JP 2007257442**

(43) Date of publication of application:
**08.04.2009 Bulletin 2009/15**

(73) Proprietors:
• **Tokyo Institute of Technology
Meguro-ku
Tokyo-to (JP)**
• **USHIODENKI KABUSHIKI KAISHA
Chiyoda-ku,
Tokyo 100-0004 (JP)**

(72) Inventors:
• **Hosokai, Tomonao
Tokyo-to (JP)**

• **Horioka, Kazuhiko
Yokohama-shi,
Kanagawa-ken (JP)**
• **Seki, Kyohei
Himeji-shi
Hyogo-ken (JP)**
• **Yokoyama, Takuma
Gotenba-shi,
Shizuoka-ken (JP)**

(74) Representative: **Tomerius, Isabel et al
Lang & Tomerius
Patentanwälte
Landsberger Strasse 300
80687 München (DE)**

(56) References cited:
**WO-A-2005/060321    JP-A- 6 325 708**

**Description**

Background of the Invention

Field of the Invention

The present invention relates to a method of generating extreme ultraviolet radiation and an extreme ultraviolet light source device for emitting extreme ultraviolet (EUV as used herein) radiation of a wavelength of 13 to 14 nm, and particularly, a wavelength of 13.5 nm.

Description of Related Art

With the micro-miniaturization and higher integration of semiconductor integrated circuits, there are demands for improved resolution in projection lithography devices used in manufacturing integrated circuits. Lithography light-source wavelengths have gotten shorter, and extreme ultraviolet light source devices (hereafter, EUV light source devices) that radiate extreme ultraviolet (hereafter EUV) radiation with wavelengths from 13 nm to 14 nm, and particularly, the wavelength of 13.5 nm, have been developed as a next generation semiconductor lithography light source to follow excimer laser devices to meet these demands.

A number of methods of generating EUV radiation are known in EUV light source devices; one of these is a method in which high temperature plasma is generated by heating and excitation of an extreme ultraviolet radiating species (hereafter EUV radiating species) and extracting the EUV radiation radiated from the plasma. EUV light source devices using this method can be roughly divided, by the type of high temperature plasma generation, into LPP (laser-produced plasma) type EUV light source devices and DPP (discharge-produced plasma) type EUV light source devices (see, "Status and Prospects of Research on EUV (Extreme Ultraviolet) Light Sources for Lithography," J. Plasma Fusion Res. Vol. 79, No.3, p. 219-260, March 2003, for example).

LPP-type EUV light source devices use EUV radiation from a high temperature plasma produced by irradiating a solid, liquid, or gaseous target with a pulsed laser. DPP-type EUV light source devices, on the other hand, use EUV radiation from a high temperature plasma produced by electrical current drive.

There have also been, in recent years, proposals to generate EUV radiation from high temperature plasma generated by a combination of gasification of a high temperature plasma raw material for EUV generation (also called a high temperature plasma raw material hereafter) by irradiation of a laser beam and heating with a large, discharge-based current (see, JP-A-2007-515741 and corresponding US 2008/116400 A and WO 2005/004555 A1, JP-A-2007-505460 and corresponding US 2007/0090304 A1, and WO 2005/101924 A1). This method is called the LAGDPP (laser assisted gas discharge produced plasma) method hereafter.

A radiating species that radiates 13.5 nm EUV radiation-that is, Xe (xenon) with a valence of about 10 as a high temperature plasma raw material for generation of EUV-is known in both these types of EUV light source devices, but Li (lithium) and Sn (tin) ions have been noted as high temperature plasma raw materials that yield a greater radiation intensity. For example, Sn has a conversion efficiency, which is the ratio of 13.5 nm wavelength EUV radiation intensity to the input energy for generating high temperature plasma, several times greater than that of Xe.

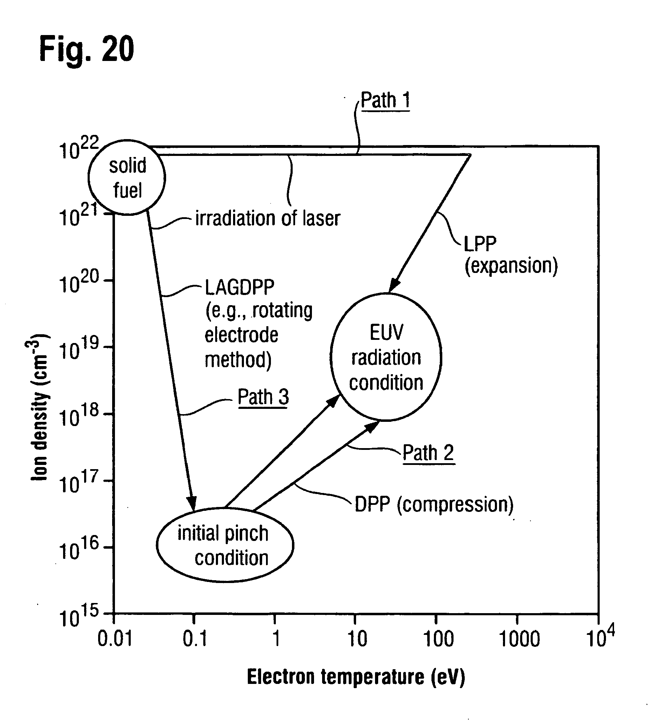

Next, the mechanisms for arriving at EUV radiation on the basis of the methods mentioned above are explained in brief, using Figure 20.

Figure 20 is a graph showing how high temperature plasma raw material (solid fuel is depicted as an example in Figure 20) takes a route of change of state and arrives at conditions that fulfill the conditions for EUV emission. In the figure, the vertical axis represents ion density ($cm^{-3}$) and the horizontal axis represents electron temperature (eV). In this figure, as one moves downward on the vertical axis the high temperature plasma raw material expands and ion density is reduced; a move upward indicates compression and increased ion density. As one moves to the right on the horizontal axis, the high temperature plasma raw material is heated and the electron temperature increases.

In the LPP method, an intense laser beam irradiates a target, for example, a solid or liquid high temperature plasma raw material such as Sn or Li (represented as the "fuel solid" in the upper left portion of Figure 20; in the solid state, the ion density of metallic Sn or Li is about $10^{22}$ $cm^{-3}$, and the electron temperature is 1 eV or less). The high temperature plasma raw material irradiated by the laser beam is suddenly heated to an electron temperature in excess of 300 eV and gasified, and a high temperature plasma is generated. The generated high temperature plasma expands, and the ion density in the high temperature plasma becomes from $10^{17}$ to $10^{20}$ $cm^{-3}$, with an electron temperature of about 20 eV to 30 eV. EUV radiation is emitted from high temperature plasma that has reached such a state (Figure 20, path 1).

That is, in the LPP method, the plasma that is generated by laser beam heating expands, by which means the plasma fulfills the conditions for EUV emission stated above (ion density from $10^{17}$ to $10^{20}$ $cm^{-3}$ and electron temperature from 20 to 30 eV).

In the DPP method, on the other hand, there is a gaseous high temperature plasma raw material atmosphere within the discharge vessel in which the electrodes are located, and the initial plasma is generated by starting a discharge between the electrodes in that atmosphere.

For example, the high temperature raw material Sn is supplied to the discharge vessel in the gaseous form called stannane ($SnH_4$), and the initial plasma is formed by discharge. The ion density in the initial plasma is, for example, about $10^{16}$ cm$^{-3}$ with an electron temperature of 1 eV or less, for example, which does not fulfill the conditions for EUV emission stated above (ion density from $10^{17}$ to $10^{20}$ cm$^{-3}$ and electron temperature from 20 eV to 30 eV) (Initial state of pinch in Figure 20).

Because of the action of the self-magnetic field inherent to the DC current flowing between the electrodes during discharge, the initial plasma is constricted in the radial direction of the current path. This increases the density of the initial plasma, and the plasma temperature also rises sharply. This action is called the pinch effect hereafter. Because of heating due to the pinch effect, the now-high temperature plasma reaches an ion density from $10^{17}$ cm$^{-3}$ to $10^{20}$ cm$^{-3}$ and electron temperature from 20 eV to 30 eV, and EUV radiation is emitted from the plasma (Figure 20, path 2).

In other words, in the DPP method, because of compression of the plasma generated, that plasma fulfills the conditions for EUV emission stated above (both ion density from $10^{17}$ to $10^{20}$ cm$^{-3}$ and electron temperature from 20 to 30 eV).

In the LAGDPP method, moreover, a laser beam irradiates a solid or liquid target (the high temperature plasma raw material) and produces a gaseous high temperature plasma raw material atmosphere (initial plasma) by gasifying the raw material. As in the DPP method, the ion density in the initial plasma is, for example, about $10^{16}$ cm$^{-3}$ with an electron temperature of 1 eV or less, for example, which does not fulfill the conditions for EUV emission stated above (ion density from $10^{17}$ cm$^{-3}$ to $10^{20}$ cm$^{-3}$ and electron temperature from 20 eV to 30 eV) (Initial state of pinch in Figure 20). Then, because of compression and heating driven by the discharge current, the now-high temperature plasma reaches an ion density from $10^{17}$ cm$^{-3}$ to $10^{20}$ cm$^{-3}$ and electron temperature from 20 eV to 30 eV, and EUV radiation is emitted from the plasma.

Examples of LAGDPP are described in the above mentioned JP-A-2007-515741 and corresponding WO 2005/004555 A1, JP-A-2007-505460 and corresponding US 2007/0090304 A1, and WO 2005/101924 A1. In all of these documents, it is stated that the high temperature plasma raw material is gasified to produce a "cold plasma," and the pinch effect from the discharge current is used to generate high temperature plasma, with EUV radiation being emitted from this high temperature plasma. That is, according to conventional examples, in the discharge-current-driven heating of the LAGDPP method, as in the DPP method, the pinch effect is used. In other words, a high temperature plasma that fulfills the conditions for EUV emission follows path 3 → path 2 in Figure 20.

In the case of the LPP method, the high temperature plasma generated by laser beam irradiation of the high temperature plasma raw material expands and cools within a short period. Consequently, the high temperature plasma that has achieved the conditions for EUV emission cools within a short period (10 ns, for example) and no longer fulfills the conditions for EUV emission, and so EUV emission from the plasma stops.

In the DPP method and the LAGDPP method, on the other hand, a pulsed discharge current flows between the discharge electrodes, as described above, and the initial plasma of high temperature plasma raw material is compressed and heated by the pinch effect and so reaches the conditions for EUV emission.

Within a short period, however, the high temperature plasma that is constricted in the radial direction of the discharge current path expands rapidly in the direction of the discharge current path as the discharge current rapidly diminishes, and the pinch effect disappears; density declines and cooling occurs. As a result, the plasma in the discharge region no longer fulfills the EUV emission conditions, and so EUV emission from the plasma stops.

Now, the discharge between the electrodes starts with a laser-triggered vacuum arc discharge in a relatively broad region and shifts to a gas discharge (including the pinch discharge) along with the supply of high temperature plasma raw material. Then a discharge column (plasma column) is formed, and what is called the "discharge region" in this specification is defined as a space that includes all these discharge phenomena.

Further, within the discharge region, when the internal current density of the discharge increases and the discharge shifts to a gas discharge as the discharge column (plasma column) grows, there is a spatial region with high current density in the discharge column in which discharge-driven current is dominant; this spatial region is defined as a "discharge channel." Here, the discharge channel is the region where discharge-driven current is the dominant flow, and so this discharge channel is also called a discharge path or discharge current path.

Pulse stretching of the EUV emission is explained next.

As noted above, an EUV emission is produced in a pulse shape within a short period of time. Therefore, the energy conversion efficiency is markedly low. When an EUV light source device is used as a light source for semiconductor lithography, both high output and efficiency that is as high as possible is operationally demanded of the EUV light source device. High-efficiency, high-output EUV radiation sources are possible if high-efficiency EUV generation conditions can be maintained for a long period. As a result, pulse stretching of the light-emission pulse width is desired.

A method of stretching pulses of EUV emission in DPP-type EUV generation devices is disclosed WO 2006/120942 A1 and JP-A-2007-123138. Based on WO 2006/120942 A1 and JP-A-2007-123138, this conventional pulse stretching method is explained below with reference to Figures 21 & 22.

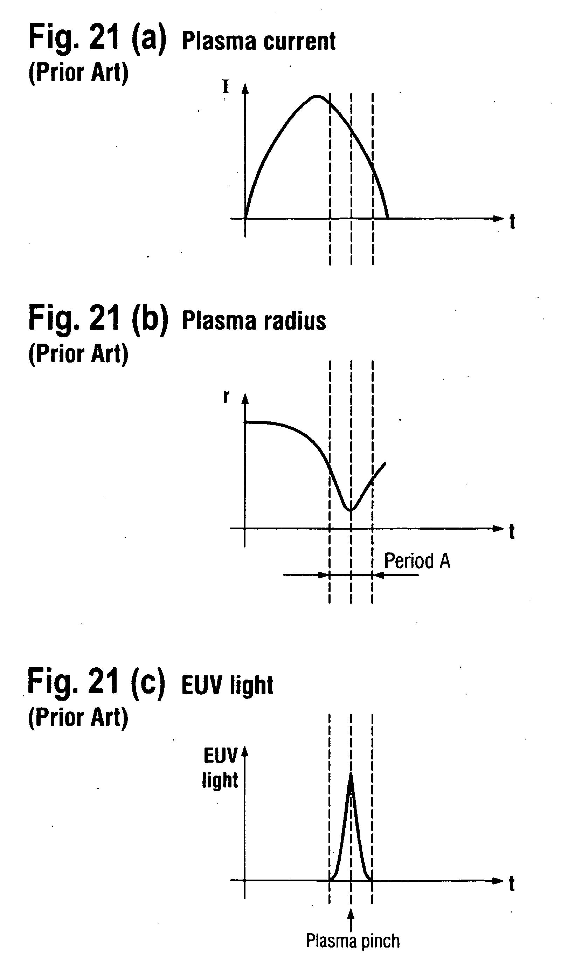

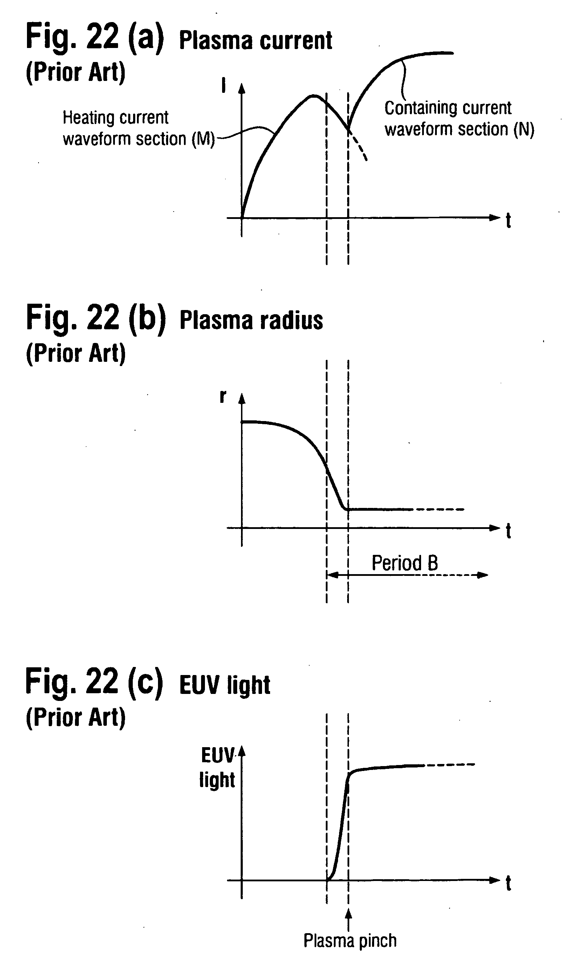

Both of Figures 21 & 22 are graphs in which (a) the plasma current I, (b) the plasma radius r, and (c) the EUV radiation output are plotted in relation to the passage of time beginning with the start of discharge. The horizontal axis represents the time and the vertical axis represents the plasma current I, the plasma radius r, and the EUV radiation output.

The pulse stretching of EUV radiation in WO 2006/120942 A1 and JP-A-2007-123138 is realized in DPP-type EUV producing devices by separating and controlling the plasma heating and compression process and the process of maintaining a state of high temperature and high pressure.

In the conventional DPP method, as shown in Figure 21, the waveform of the plasma current I that flows within uniform plasma columns formed between a pair of electrodes is a waveform that increases with the passage of time after the start of discharge, and then decreases after the peak is passed. For ease of understanding, the waveform of the current I is taken as a sine wave below.

Heating and compression of the plasma occur as the plasma current I increases. That is, the radius r of the generated plasma column grows smaller and smaller, due to the pinch effect, as the plasma current I flows; it is smallest when the value of the plasma current I has passed its peak and begun to fall.

EUV emission occurs during time period A, in the vicinity of the peak of the plasma current I waveform, when the plasma temperature and ion density are within the specified range (as shown in Figure 20, for example, the electron temperature is from 5 eV to 200 eV and the ion density is about $10^{17}$ cm$^{-3}$ to $10^{20}$ cm$^{-3}$).

When the peak of the plasma current I waveform is passed, however, the current value diminishes with the passage of time, and so the pinch effect also weakens; the plasma expands and the plasma temperature drops. The expanding plasma has great kinetic energy and quickly breaks away from the discharge region. The EUV emission stops as a result. The duration of the EUV emission is, for example, a mere 10 ns.

On the other hand, the method described in WO 2006/120942 A1 and JP-A-2007-123138 is constituted so that the waveform of the plasma current I flowing between a pair of electrodes becomes the waveform shown in Figures 22 (a) to 22(c). That is, the waveform of the plasma current I increases with the passage of time after the start of discharge, and in the vicinity after the peak is passed (for example, in the vicinity when the plasma is pinched, causing EUV emission to start), it increases further with the passage of time.

As shown in Figures 22(a) to 22(c), the waveform of the plasma current I comprises a heating current waveform component (M) and a subsequent confinement current waveform component (N). The heating current waveform component (M) is the same, up to a certain point in time, as the waveform of the plasma current I shown in Figure 21. In Figures 22(a) to 22(c), the heating current waveform component (M) is shown as a sine wave for ease of understanding.

Plasma heating and compression occur along with the increase of the plasma current I during the period of the heating current waveform component (M). That is, the radius r of the generated plasma column grows smaller and smaller, due to the pinch effect, as the plasma current I flows; it is smallest when the value of the plasma current I has passed its peak and begun to fall. EUV emission occurs in the vicinity of the peak of the plasma current I waveform, when the plasma temperature and ion density are within the specified range (as shown in Figure 20, for example, the electron temperature is from 5 eV to 200 eV and the ion density is about $10^{17}$ cm$^{-3}$ to $10^{20}$ cm$^{-3}$).

After EUV emission occurs, the waveform of the plasma current I shifts to the confinement current waveform component N.

As stated above, the plasma compressed by the pinch effect attempts to expand with great kinetic energy. Here, when the strength of the plasma current I increases and the action of the self-magnetic field becomes powerful, it becomes possible to maintain in a compressed state the plasma that is trying to expand.

Taking the pressure of the plasma in this pinched state as $P_{pp}$, the plasma density as $n_{pp}$, the Boltzmann coefficient as k, and the plasma temperature as $T_{pp}$, then the pressure of the plasma in the pinched state $P_{pp}$ is proportional to $n_{pp}kT_{pp}$.

$$P_{pp} \propto n_{pp}kT_{pp} \qquad\qquad (1)$$

On the other hand, the compression pressure $P_B$ that results from the self-magnetic field B inherent to the plasma current I, when magnetic permeability in a vacuum is $\mu_0$ and the plasma radius is r, is represented by

$$P_B = \mu_0\, I^2 / 2\pi r \qquad\qquad (2)$$

Here, if the condition

$$P_B \gg P_{pp} \qquad\qquad (3)$$

is met, the plasma can be maintained in a pinched state. The plasma in a pinched state here has become high temperature plasma with a great plasma density $n_{pp}$ and plasma temperature $T_{pp}$, and so because of formula (3) it is necessary to increase the plasma current I.

In other words, by increasing the plasma current I after the plasma is pinched, the subsequent current value can be held steady, by which means the pinch effect is maintained, and so the plasma temperature and ion density are maintained within the specified range (a state in which the plasma radius is small).

Theoretically, while the plasma temperature and ion density are maintained in a state within the specified range (period B in Figure 22), an EUV emission can continue. In other words, pulse stretching of the EUV emission becomes possible.

The example shown in Figures 22(a) to 22(c) is one in which the point in time at which the plasma is pinched and the plasma radius is at its smallest is the point of transition from the heating current waveform component (M) to the confinement current waveform component (N).

Now, in reality, even with a plasma current I that has a confinement current waveform component (N) that maintains a peak current value exceeding the peak of the heating current waveform component (M), it is difficult to maintain the high temperature plasma in a compressed state for a long period, due to such reasons as plasma column collapse due to the growth of fluid instability. For this reason, the confinement current waveform component (N) eventually diminishes with the passage of time; the pinch effect weakens, the plasma expands, and the plasma temperature declines. The EUV emission ends as a result. In the example in WO 2006/120942 A1, it is stated that the duration of EUV power (duration of high temperature plasma) can be pulse-lengthened to about 30 ns.

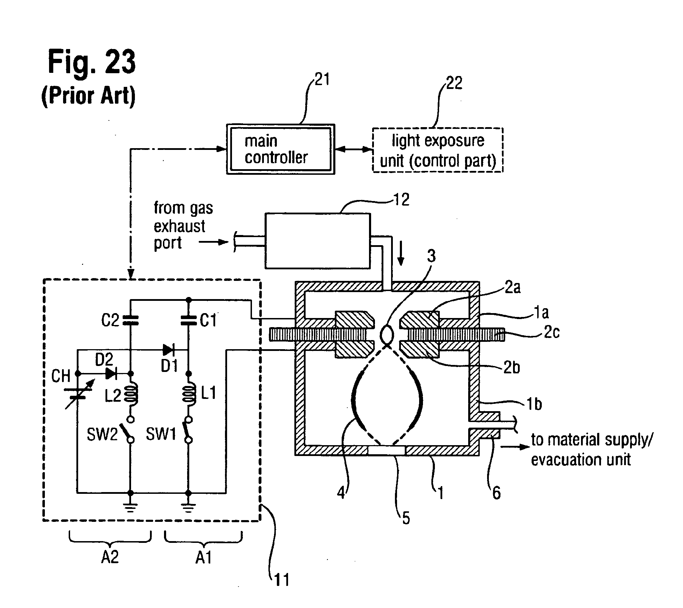

Figure 23 is an example of the constitution of a DPP-type EUV light source device to realize the EUV emission pulse stretching method described in WO 2006/120942 A1 and JP-A-2007-123138.

High temperature plasma raw material is introduced into the chamber 1, which is the discharge vessel, by a raw material supply/evacuation unit 12. The high temperature plasma raw material is a raw material for formation of a radiating species that emits EUV radiation with a wavelength of 13.5 nm in the high temperature plasma generation part 3 in the chamber 1; it is, for example, xenon (Xe) or Sn vapor. The high temperature plasma raw material introduced flows within the chamber 1 and reaches the gas evacuation port 6.

A raw material supply/evacuation unit 12 has a vacuum pump or other evacuation means (not illustrated); the evacuation means is connected to the gas evacuation port 6 of the chamber.

That is, the high temperature plasma raw material that reaches the gas evacuation port 6 is evacuated by the evacuation means of the raw material supply/evacuation unit 12.

A ring-shaped first main discharge electrode (cathode) 2a and a second main discharge electrode (anode) 2b, separated by an insulator 2c, are located in the chamber 1. The chamber 1 comprises a first vessel 1a, formed of conductive material, on the first main discharge electrode side and a second vessel 1b, similarly formed of conductive material, on the second main discharge electrode side. The first vessel 1a and the second vessel 1b are separated and insulated by the insulator 2c.

The second vessel 1b and the second main discharge electrode 2b of the chamber 1 are grounded, and a pulsed power generator 11 applies a voltage of about -5 kV to -20 kV on the first vessel 1a and the first main discharge electrode 2a. As a result, a discharge is generated in the high temperature plasma generation part 3 between the ring-shaped first and second main discharge electrodes 2a, 2b, a high temperature plasma is generated by the above-mentioned pinch effect, and an EUV radiation with a wavelength of 13.5 nm is generated by this high temperature plasma. The EUV radiation thus generated is reflected by EUV collector optics 4 and is output to an unillustrated irradiation area by an EUV radiation extraction area 5.

Incidentally, the waveform of the plasma current (discharge current) shown in Figure 22(a) is obtained as follows, for example. A current having a sinusoidal waveform is overlapped by another current with a waveform that is not sinusoidal. In other words, a current that has a heating current waveform component (M) is overlapped with a current of a pattern that differs from the heating current waveform component (M) to form a confinement current waveform component (N).

In order to obtain this sort of current waveform, the high-voltage pulsed power generator 11 is constituted with a parallel discharge circuit having independent switching elements SW1, SW2 as shown in Figure 23.

The pulsed power generator 11 shown in Figure 23 comprises a discharge circuit A1 made up of a capacitor C1 and a switch SW1 in series and a discharge circuit A2 made up of a capacitor C2 and a switch SW2 in series, the two being connected in parallel to the load (the first main discharge electrode 2a and the second main discharge electrode 2b. Here, the high-voltage power source CH has the purpose of charging the capacitors C1, C2. Further, a coil L1 represents the inductance component compounding the parasitic inductance of the capacitor C1 and the inductances of the circuit loop formed by the capacitor C1, the switch SW1, and the load. Similarly, a coil L2 represents the inductance component compounding the parasitic inductance of the capacitor C2 and the inductances of the circuit loop formed by the capacitor C2, the switch SW2, and the load. Further, diodes D1, D2 have the purpose of limiting the current direction so that the electrical energy stored in the capacitors C1, C2 is transferred only to the load.

The high-voltage pulse generator shown in Figure 23 operates as follows. First the high-voltage power source CH charges the capacitors C1, C2 of the discharge circuits through the diodes D1, D2. Then by turning the first switch SW1 of the discharge circuit A1 ON, the electrical energy stored in the first capacitor C1 is applied between the first main discharge electrode 2a and the second main discharge electrode 2b and discharge begins. At that time, the current flowing between the first main discharge electrode 2a and the second main discharge electrode 2b is used to pinch the plasma. That is, due to Joule heating by the pinch effect, a high temperature plasma is generated. This current corresponds to the heating current waveform component (M) in the waveform of Figure 22(a).

Next, by turning the second switch SW2 of the discharge circuit A2 ON at the point of time at which the emission of EUV radiation with a wavelength of 13.5 nm begins by the pinch effect, the electrical energy stored in the second capacitor C2 is applied between the first main discharge electrode 2a and the second main discharge electrode 2b, and the current from the second capacitor C2 is added to the current flowing between the first main discharge electrode 2a and the second main discharge electrode 2b. This current is used as a current for maintaining the pinched state of the high temperature and high density plasma and this current corresponds to the confinement current waveform component (N) in Figure 22(a). Now, the first switch SW1, the second switch SW2 and the raw material supply/evacuation unit 12 are controlled by the main controller 21. The main controller 21 controls them based on the operation command signal of the control part 22 of lithography tool.

In the EUV emission pulse stretching method of the prior art described above, on the other hand, the EUV emission pulse stretching shown in WO 2006/120942 A1 and JP-A-2007-123138 can be realized in DPP-type EUV light source devices by separating and controlling the plasma heating and compression process and process of maintaining a state of high temperature and high-pressure. In other words, in order to maintain the pinched state of the plasma, it is necessary to supply energy to the discharge space so that the value of the plasma current I after the plasma arrives at the pinched state will be greater than the value of the plasma current I before the plasma arrives at the pinched state, as shown in Figure 22(a), in contrast to the conventional DPP method.

At the completion of the EUV emission, the energy supplied to the discharge space is converted to heat. In order to maintain the pinched state of plasma in DPP-type EUV light source devices employing traditional pulse stretching methods, a greater discharge current flows than in the ordinary DPP method without pulse stretching technology. For that reason, the heat input to the electrodes in this sort of EUV light source device is greater than in conventional DPP-type EUV light source devices. Therefore, the heat load causes partial melting or vaporization or spattering of the electrodes, and so debris is formed, and this debris is liable to bring about the problem of damage to the EUV collector optics.

Moreover, in order to maintain the pinched state of the plasma, it is necessary to change the waveform of the plasma current I as shown in Figure 22(a). Here, the period for which the plasma is pinched in a high temperature state because of the heating current waveform component (M) of the plasma current I waveform shown in Figure 22(a) is about 10 ns, and so in order to maintain the pinched state, it is necessary for the plasma current I to flow within this period so as to generate a confinement current waveform component (N) of the plasma current I waveform.

In other words, the time tolerance for the flow of current to generate the confinement current waveform component (N) of the current waveform must be about 10 ns or less; highly precise control is required for synchronization of the timing of the switches SW1, SW2.

This invention was made in consideration of the situation described above; the object of this invention being to provide an EUV light source device and an EUV generating method that is capable of realizing EUV emission pulse stretching without imposing a great heat load on the electrodes, and without requiring highly precise control, as in the prior art. EUV-generating methods according to the preamble of claim 1 and EUV-generating devices according to the preamble of claim 9 are described in WO 2005/060321 A and JP 06 325708 A.

Summary of the Invention

The method for generating extreme ultraviolet radiation (an EUV radiation generation method) according to the present invention basically uses the DPP method. Unlike the prior art that needs to flow high current to a discharge area in order to keep plasma in the pinch state as a result of the pinch effect, the present invention can achieve pulse-stretched EUV radiation by maintaining high temperature plasma that satisfies the aforementioned EUV emission conditions (i.e., ion density and electron temperature are approximately $10^{17}$ to $10^{20}$ cm$^{-3}$ and approximately 20 to 30 eV, respectively).

The present invention consists of a method of generating extreme ultraviolet radiation according to the subject-matter of claim 1 and of an extreme ultraviolet light source device according to the subject-matter of claim 9.

Brief Description of Drawings

Fig. 1 is a graph showing paths for high temperature plasma material to satisfy EUV emission conditions in the present invention.

Fig. 2(a)-2(c) are graphs showing the long pulsing method (multi-pinch method) according to the present invention.

Fig. 3(a)-3(c) are graphs showing the long pulsing method (non-pinch method) according to the present invention.

Fig. 4 is a view showing the basic configuration of the EUV light source device according to the present invention.

Fig. 5(a)-5(e) are time charts for explaining the EUV generation method according to the present invention.

Fig. 6(a) & 6(b) are views showing the orienting mechanism according to the present invention.

Fig. 7(a)-7(c) are views showing the orienting mechanism according to the present invention.

Fig. 8 is a view showing the orienting mechanism according to the present invention.

Fig. 9(a) & 9(b) are views showing the orienting mechanism according to the present invention.

Fig. 10(a) & 10(b) are views showing the positional relationship among electrodes, high temperature plasma material and energy beams (laser beams).

Fig. 11(a) & 11(b) are views showing the positional relationship among electrodes, high temperature plasma material and energy beams (laser beams).

Fig. 12 is a schematic view showing the configuration of an EUV light source device using the extreme ultraviolet (EUV) radiation generation method according to a first embodiment of the present invention.

Fig. 13 is a circuit diagram showing the configuration of the equivalent circuit of a power supply means.

Fig. 14 is a flowchart showing the operation of the first embodiment.

Fig. 15 is a time chart showing the operation of the first embodiment.

Fig. 16 is a view for explaining a second embodiment according to the present invention.

Fig. 17 is a view showing the configuration of an EUV light source device using the extreme ultraviolet (EUV) radiation generation method according to the second embodiment of the present invention.

Fig. 18 is a flowchart showing the operation of the second embodiment.

Fig. 19 is a time chart showing the operation of Embodiment 2.

Fig. 20 is a graph showing paths for high temperature plasma material to satisfy EUV emission conditions.

Fig. 21(a)-21(c) are graphs showing the relationship among plasma current I, the radius r of a plasma column and EUV radiation outputs in an EUV generation device of the conventional DPP method.

Fig. 22(a)-22(c) are graphs showing the relationship among pulse-stretched plasma current I, the radius r of a plasma column and EUV radiation outputs in an EUV generation device of the conventional DPP method.

Fig. 23 shows an example of the configuration of an EUV light source device of the conventional DPP method for achieving pulse-stretched EUV radiation.

Detailed Description of the Invention

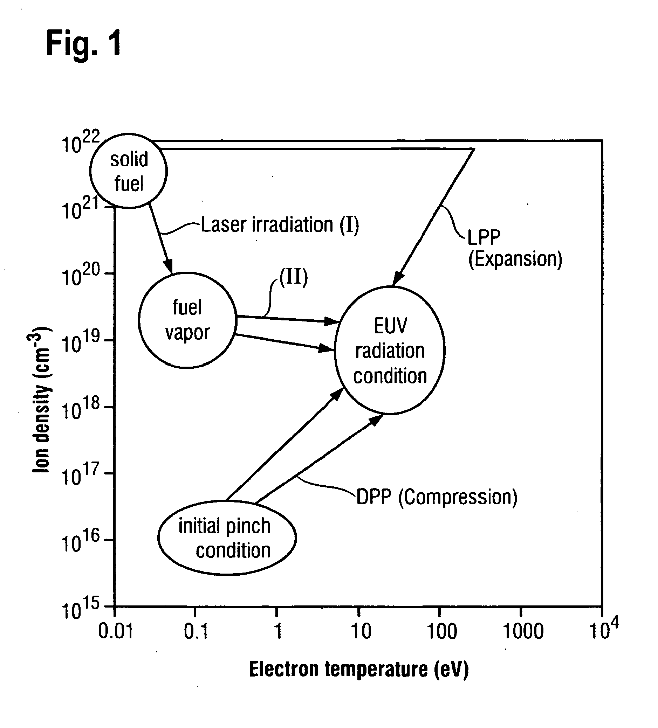

The DPP-type high temperature plasma generation of this invention is explained using figure 1. Now, the vertical and horizontal axes of figure 1 are the same as those of Figure 20.

An energy beam irradiates solid or liquid high temperature plasma raw material (a fuel solid is shown, as an example, in Figure 1) located outside the discharge region. A laser beam, for example, is used as the energy beam. The following explanation utilizes a laser beam as an example of the energy beam.

The solid or liquid high temperature plasma raw material irradiated by the laser beam is heated and gasified, and reaches the discharge channel formed in advance in the discharge region. Here, the irradiation energy of the laser beam is set appropriately so that when the gasified high temperature raw material reaches the discharge region, there will be an ion density of about $10^{17}$ cm$^{-3}$ to $10^{20}$ cm$^{-3}$ and an electron temperature not exceeding 1 eV in the plasma. In other words, laser beam irradiation of the high temperature plasma raw material will form a low temperature plasma gas such that the ion density in the plasma fulfills the condition for EUV emission but the electron temperature is a low temperature (path (I) of Figure 1).

This low temperature plasma is supplied to the discharge channel formed in advance in the discharge region between the electrodes, and the low temperature plasma is heated by the discharge current. Here, the ion density of the low temperature plasma gas has already met the condition for EUV emission, so it is acceptable if the conventional DPP-type pinch-effect compression is small. In other words, the current flowing between the electrodes primarily contributes only to heating of the low temperature plasma, heating brings the electron temperature to between 20 eV and 30 eV, and EUV is emitted by the high temperature plasma that has reached EUV emission conditions (path (II) of Figure 1).

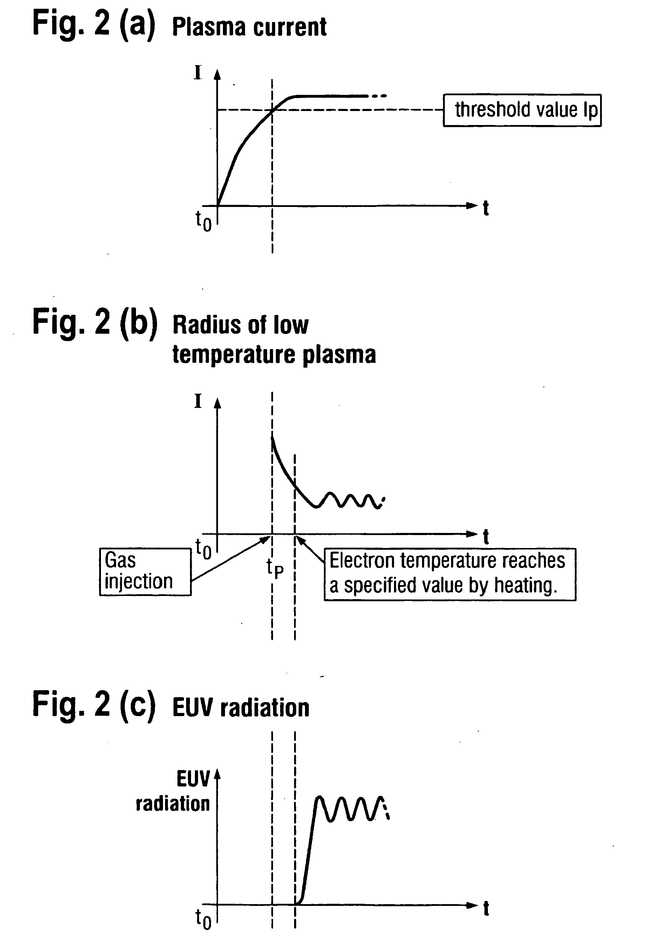

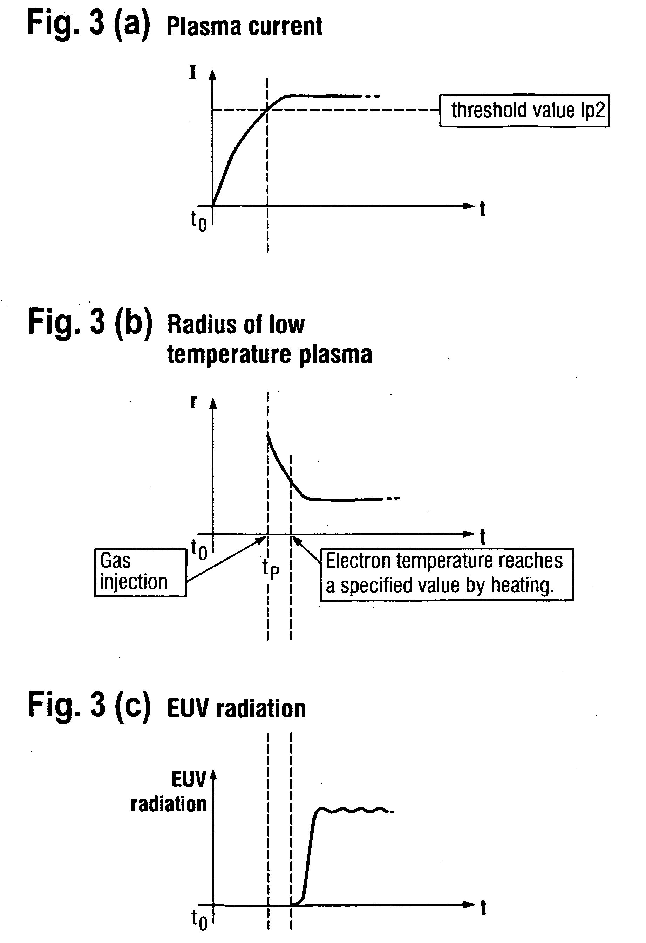

Here, the low temperature plasma gas is supplied continually to a discharge channel formed beforehand between the electrodes, by which means it becomes possible to achieve pulse stretching of the EUV emission. The pulse stretching method is explained below, using Figures 2(a) to 2(c) & 3(a) to 3(c).

Now, Figure Figures 2(a) to 2(c) shows the multi-pinch method and Figure Figures 3(a) to 3(c) shows the non-pinch method.

Figures 2(a) to 2(c) are graphs to explain the plasma current, the low temperature plasma radius and EUV emission in the multi-pinch method.

Power is supplied between the electrodes, and at the time t = $t_0$ (by application of the trigger) vacuum discharge starts and current begins to flow, and a discharge channel (discharge current path) is formed (Figure 2(a)). At the point tp when the current I reaches the threshold value Ip, which is described hereafter, the cross-sectional size of the discharge channel narrows under the effect of the self-magnetic field inherent in the current.

On the other hand, at the point tp noted above, the high temperature plasma raw material gasified by laser beam irradiation (that is, the low temperature plasma gas with an ion density corresponding to EUV emission conditions but a lower electron temperature) is made to arrive selectively at the narrow discharge channel flowing in the discharge region.

Here, the current threshold value Ip, when $P_B$ is the compression pressure due to the self-magnetic field inherent to the current and $P_p$ is the pressure of the plasma, is set as

$$P_B \gg P_p \qquad\qquad\qquad (4)$$

In other words, it is a current value at which adequate compression of the low temperature plasma gas by the self-magnetic field is possible.

Now, the threshold value Ip is a current value having energy capable of heating low temperature plasma (ion density from $10^{17}$ cm$^{-3}$ to $10^{20}$ cm$^{-3}$ and electron temperature not exceeding 1 eV) to an electron temperature of 20 eV to 30 eV or higher.

The low temperature plasma that is selectively supplied to the narrow discharge channel mentioned above is produced by laser beam irradiation of a solid or liquid high temperature plasma raw material, as mentioned above. The laser beam emission conditions are set appropriately on the basis of such things as the distance to the discharge region from the high temperature plasma raw material located outside the discharge region. The irradiation energy is at a level that can gasify the solid or liquid high temperature plasma raw material without raising the electron temperature too much (note: laser radiation raises the electron temperature slightly, as shown in Figure 1), in the range from $10^5$ W/cm$^2$ to $10^{16}$ W/cm$^2$, for example.

Irradiating the solid or liquid high temperature plasma raw material with this sort of laser beam makes it possible to supply high temperature plasma raw material with an ion density that corresponds to EUV emission conditions and a low electron temperature (low temperature plasma gas) between the electrodes continuously for a period of about 10 $\mu$s.

The discharge duration in the conventional DPP method or LAGDPP method is generally about 2 $\mu$s. That is, compared to the conventional discharge duration, the supply of the low temperature plasma gas stated above can be considered to be a continuous steady supply.

The laser emission conditions and conditions, such as the location of the high temperature plasma raw material, are set appropriately so that the low temperature plasma gas selectively arrives at the narrow discharge channel. This type of adjustment is used to constitute a flow of gasified high temperature plasma raw material (low temperature plasma gas) with good directionality and to set that flow so that it is supplied focused on the vicinity of the narrow discharge channel. By means of such a constitution, low temperature plasma gas can be supplied continuously and selectively to the narrow discharge channel.

Now, when the solid or liquid high temperature plasma raw material is located inside the discharge region, the energy from the discharge acts directly on the high temperature plasma raw material and the conditions for vaporization of the high temperature plasma raw material change from moment to moment. It is not possible, therefore, to continuously and selectively supply low temperature plasma gas with an ion density that corresponds to EUV emission conditions and a low electron temperature to a narrow discharge channel.

The low temperature plasma gas supplied to the narrow discharge channel, heated by the pinch effect of current at a value at or above the threshold value Ip or by the confinement effect of the self-magnetic field, becomes high temperature plasma and EUV is emitted by the high temperature plasma.

Here, the EUV emission is realized by the path (II) in figure 1, and so there is little compression from the pinch effect and a large proportion of the heating process is due to the confinement effect and Joule heating due to the self-magnetic field. In other words, there is not a large current as in the conventional DPP method and LAGDPP method, and EUV emission is possible even though a relatively small current is flowing through the discharge region. Further, it is possible to effectively input energy (that is, to heat) the plasma even without fast, short pulses of discharge current. Accordingly, it is possible to set the discharge current pulses longer than in the prior art.

Immediately following maximum compression, the compressed high temperature plasma is pushed out along a plasma density slope in the direction of the discharge channel axis, and largely departs from the direction of the discharge channel axis. At the same time, the discharge channel expands in the diametric direction, and as a result, the plasma density and electron temperature within the discharge channel fall sharply. In the prior art, the EUV emission is completed at this point.

However, there is a steady flow of low temperature plasma gas surrounding the discharge channel, as stated above, and so when the plasma density in the discharge channel drops, low temperature plasma gas is supplied to that space with no time lag. Accordingly, before the diameter of the discharge channel has expanded appreciably, the discharge channel is again narrowed by the pinch effect or by the confinement effect of the self-magnetic field; the low temperature plasma is heated, and the EUV emission continues by the mechanism described above (Figures 2(b) & 2(c)).

Repetition of this type of pinch effect or the confinement effect of the self-magnetic field sustains the period for which the discharge current continues.

Now, rapid and short pulses are not necessary in this invention, as stated above, and so it is possible to set the discharge current pulses longer than in the prior art. That is, repetition of this sort of pinch effect or confinement effect of the self-magnetic field can be maintained for a long period, and so it is possible to bring about EUV emission pulse stretching. This method of continuous use of the pinch effect is called the "multi-pinch" method hereafter.

In the conventional DPP method using the pinch effect, low ion-density, high temperature plasma raw material is supplied to the discharge region (pinch start conditions in Figure 1). The low density gas more or less fills the entire discharge vessel (discharge region). The discharge channel resulting from the initial plasma produced by discharge in a low-density gas atmosphere has an initial shape as broad as the diameter of the discharge vessel, and so a current pulse with great power is necessary to narrow the discharge channel by the pinch effect and turn the initial plasma into high temperature plasma. Moreover, fast and short pulses of discharge current must be applied in order to increase the efficiency of energy input into the plasma from the discharge. Accordingly, the EUV emission is completed with a single pinch effect, and the pulse width of the EUV emission is about 200 ns at the most (path 2 of Figure 20).

Further, in the conventional DPP method, when the first pinch ends and the plasma density in the discharge channel drops, low-density gas (high temperature plasma raw material) in the discharge vessel infiltrates that region, and so the discharge channel broadens and returns to the diameter of the initial state in the first pinch effect. Accordingly, if one attempts to execute multi-pinches, it requires a large current, the same as for the first pinch. In actuality, the discharge current is in fast and short pulses, as stated above, and so it is impossible to execute a second pinch in the time that remains after the first pinch.

The pinch effect is used in the LAGDPP method as well, and the EUV emission occurs by way of path 3 and then path 2 of Figure 20. That is, the low-density, high temperature plasma gas is supplied to the discharge region by means of laser irradiation of the high temperature plasma raw material.

Beyond that, as in the case of the DPP method, the initial plasma is generated by discharge in a low-density gas atmosphere, and a high-power current pulse is necessary to make the initial plasma into a high temperature plasma by means of the pinch effect, as well as realization of fast and short pulses of discharge current.. Therefore, the EUV emission ends with a single pinch effect.

As in WO 2005/101924 A1, in the LAGDPP method the discharge occurs after the high temperature plasma raw material gas is released by laser beam irradiation, and so a large proportion of high temperature plasma raw material gas escapes from the discharge region without being heated, which is inefficient.

In other words, in the conventional DPP method and the LAGDPP method, in order to achieve pulse stretching of the EUV emission it is necessary to adopt a method to separate and control the plasma heating and compression process and the process of maintaining compression, and to supply energy to the discharge space so that the value of the plasma current after the plasma reaches a pinched state is larger than the value of the plasma current before the plasma reaches a pinched state, as in WO 2006/120942 A1 or JP-A-2007-123138.

Incidentally, the current threshold value Ip2, when $P_B$ is the compression pressure due to the self-magnetic field inherent to the current and $P_p$ is the pressure of the plasma, is set as

$$P_B \geqq P_p \qquad\qquad (5)$$

Even in the event of a current value such that the low temperature plasma gas is weakly compressed by the self-magnetic field (the compression of the low temperature plasma gas is maintained at a level that the decrease of the ion density by the expanding of the low temperature gas does not occur), pulse stretching of the EUV emission is possible.

Now, the threshold value Ip2 is a current value having energy capable of heating low temperature plasma (ion density from $10^{17}$ to $10^{20}$ cm$^{-3}$ and electron temperature not exceeding 1 eV) to an electron temperature of 20 eV to 30 eV or higher.

Figures 3(a) to 3(c) are graphs to explain the plasma current, the low temperature plasma radius, and EUV emission in the case of the non-pinch method. The non-pinch method is explained below with reference to Figure 3.

Power is supplied between the electrodes, and at the time t = to, discharge starts and current begins to flow (Figure 3(a)). At the point tp when the current I reaches the threshold value Ip2, the cross-sectional size of the discharge channel narrows under the effect of the self-magnetic field inherent in the current. Now, to compare the current threshold value Ip when the multi-pinch effect is used and the threshold value Ip2 mentioned above, Ip > Ip2, and so and so the cross-sectional size of the discharge channel is larger than when the multi-pinch method is used.

On the other hand, at the point tp noted above, the low temperature plasma gas with an ion density corresponding to EUV emission conditions but a lower electron temperature is made to arrive selectively at the narrow discharge channel flowing in the discharge region, the same as when the multi-pinch effect is used. Now as stated above, the low temperature plasma gas is constituted to be continuously and selectively supplied to the narrow discharge channel.

The low temperature plasma gas supplied to the narrow discharge channel is hardly compressed at all by current exceeding the threshold value Ip2; this low temperature plasma gas, maintained in a state of no drop in ion density by expansion, is heated to become high temperature plasma, and EUV is emitted from the high temperature plasma. That is, because the ion density of the low temperature plasma satisfies the EUV emission conditions from the start, EUV emission can be realized by heating while maintaining the ion density (path (II) of Figure 1).

Accordingly, EUV emission is possible even with a relatively small current flowing through the discharge region, not the large current of the conventional DPP and LAGDPP methods. Further, it is possible to effectively input energy to the plasma (that is, to effectively heat the plasma) even without fast, short pulses of discharge current. Accordingly, it is possible to set the discharge current pulses longer than in the prior art.

Here, there is a steady flow of low temperature plasma gas surrounding the discharge channel, as stated above. As a result, low temperature plasma gas with the specified ion density is supplied steadily to the discharge. Accordingly, as long as the discharge current continues, the low temperature plasma is heated and the EUV emission continues (Figures 3(b) and 3(c)).

In this case as well, fast and short pulses of current are not necessary, and so it is possible to set discharge current pulses longer than in the prior art. That is, because it is possible to maintain continuous heating of low temperature plasma gas and generation of high temperature plasma over a long period, pulse stretching of the EUV emission can be realized.

In this method, the current threshold value Ip2 is a current value such that the low temperature plasma gas is weakly compressed by the self-magnetic field (the compression of the low temperature plasma gas is maintained at a level that the decrease of the ion density by the expanding of the low temperature gas does not occur), and so the low temperature plasma is heated without apparent constriction and becomes high temperature plasma. Therefore, this method is called the "non-pinch method" below.

Here, whether it is the multi-pinch method described above or the non-pinch method is decided by the broadness of the discharge channel if the driving current values are the same. Such things as the discharge electrode shape and the beam diameter of the irradiating laser beam are selected; if the discharge channel is narrow it will be the multi-pinch method and if the discharge channel is broad it will be the non-pinch method.

Now, in the non-pinch method, the discharge channel diameter is larger than in the multi-pinch method, and so the size of the high temperature plasma will also be larger than in the multi-pinch method. That is, the size of the EUV radiation source will be larger than in the multi-pinch method, and so in the event that this invention is applied to an EUV light source device for lithography, adopting the multi-pinch method rather than the non-pinch method is preferable to enable reduction of the size of the EUV radiation source.

To compare the EUV radiation extraction by the multi-pinch method with extraction from a single pinch with the same energy conversion efficiency and the same EUV output, the peak power input is smaller with the single pinch. Accordingly, it is possible to suppress the peak power input to the electrodes, and to reduce the occurrence of debris resulting from electrode spattering. Further, the number of ions that contribute to EUV luminescence in a single pinch is smaller. Therefore, the size of the light source can be reduced, which is an advantage in design of the lithography optical system.

As stated above, pulse stretching of EUV radiation can be realized in this invention in the following way.

(i) A narrow discharge channel is produced in the discharge region beforehand.

(ii) Solid or liquid high temperature plasma raw material outside the discharge region is irradiated by an energy beam and gasified, and a low temperature plasma gas is formed having an ion density corresponding to EUV emission conditions and a low electron temperature (Figure 1, fuel vapor: ion density from $10^{17}$ cm$^{-3}$ to $10^{20}$ cm$^{-3}$; electron temperature not exceeding 1 eV).

(iii) The low temperature plasma gas is selectively supplied at a steady rate to the narrow discharge channel so that the low temperature plasma gas reaches the narrow discharge channel when the discharge current reaches the specified threshold value (Ip or Ip2). As a result, the electron temperature of the low temperature plasma gas is raised by the action of the discharge and, following path II of Figure 1, a high temperature plasma that fulfills the EUV emission conditions is formed and EUV emission occurs.

(iv) Here, the low temperature plasma gas is supplied to a discharge channel formed in advance, and so there is no need for the discharge current pulses to be high current or fast and short pulses; it is acceptable for the current pulses to have slower rise times or to be longer than conventional current pulses. The EUV emission continues as long as the narrow discharge channel continues to some extent. Therefore, by forming a discharge circuit and stretching the discharge current pulses so that they are longer than those of the conventional DPP and LAGDPP methods, it is possible to make the duration of the narrow discharge channel greater than in the prior art, and pulse stretching of the EUV radiation can be realized as a result.

(v) Now, when the multi-pinch method is adopted and the current threshold value is set to be Ip, the diameter of the narrow discharge channel pulsates while the discharge current pulses continue but remains relatively narrow, and EUV radiation can be generated by repeated pinching of the low temperature plasma.

Further, when the non-pinch method is adopted and the current threshold value is set to be Ip2, the diameter of the narrow discharge channel will be broader than in the case of the multi-pinch method but remains relatively narrow; heating of the low temperature plasma continues, the plasma temperature and density necessary for EUV emission are maintained, and EUV radiation is generated.

Now, in the non-pinch method, as stated previously, the diameter of the discharge channel is greater than in the multi-pinch method and so the size of the high temperature plasma is also greater than in the multi-pinch method.

The present invention solves the aforementioned problems as follows:

(1) By a method of generating extreme ultraviolet radiation comprising the vaporization of raw material by irradiation with energy beams outside the discharge area, the generation of high temperature plasma by adding energy to the vaporized raw material gas by means of electric discharge and the generation of extreme ultraviolet radiation from the high temperature plasma, high temperature plasma is generated by forming a discharge path (i.e., a discharge channel) in the discharge area and supplying the raw material gas to the discharge path.

(2) In the aforementioned (1), an energy beam is irradiated to the discharge path in order to demarcate the discharge path (i.e., the discharge channel) by the energy beam.

(3) In the aforementioned (1) and (2), the ion density of raw material gas supplied to the discharge path (i.e., the discharge channel) is made substantially equivalent to the ion density under the emission conditions of extreme ultraviolet radiation (ion density: $10^{17}$ to $10^{20}$ cm$^{-3}$), and the raw material gas is heated by electric discharge until the temperature that satisfies the emission conditions of extreme ultraviolet radiation is reached in order to continuously generate extreme ultraviolet radiation of not less than 200 ns.

(4) In the aforementioned (1), (2) and (3), electric discharge is generated by supplying a current pulse between the electrodes, and the raw material gas is supplied to the discharge path (i.e., the discharge channel) for a period longer than the width of the current pulse including a period during which the current pulse is supplied.

(5) In the aforementioned (1), (2), (3) and (4), a laser beam is used as an energy beam.

(6) In the extreme ultraviolet light source device comprising a container, a pair of electrodes provided inside said container at a specified interval, a pulsed power generator for supplying pulsed power to said electrodes, a raw material supply means that supplies the vaporized raw material gas for emitting extreme ultraviolet radiation to a discharge path formed between said electrodes, a radiation collector means for collecting extreme ultraviolet radiation emitted from said high temperature plasma generated at said discharge path and an extreme ultraviolet radiation extraction part for extracting said collected extreme ultraviolet radiation, a discharge path is formed by the pulsed power generator by supplying pulsed power of not less than 1 μs between the electrodes. The raw material supply means comprises an energy beam irradiation means for vaporizing the raw material by irradiation with an energy beam to the raw material placed in the space outside the discharge path in such a way that the vaporized raw material can reach the discharge path in order to supply raw material gas, ion density of which is substantially equivalent to that under the emission conditions of extreme ultraviolet radiation, to the discharge path (i.e., the discharge channel).

(7) In the aforementioned (6), a second energy beam irradiation means is provided, and an energy beam is emitted from the second energy beam irradiation means to the discharge path (i.e., the discharge channel) for demarcating the discharge path by the energy beam.

(8) In the aforementioned (6) and (7), initiation material is placed in the vicinity of the electrodes and, the initiation material is supplied to the area where discharge is to be generated in advance of the discharge.

(9) In the aforementioned (6), (7) and (8), a laser beam is used as the energy beam.

Effect of the Invention

The present invention can provide the following effects.

(1) Since a narrow discharge channel is generated in a discharge area in advance, a steady flow of low temperature plasma gas in which the ion density satisfies the EUV emission conditions and electron temperature is low is selectively supplied to this narrow discharge channel, electric discharge is used to act on the low temperature plasma gas, high temperature plasma satisfying the EUV emission conditions is generated via Path II in Fig. 1 and EUV radiation is generated, discharge current is not required to be high unlike in the conventional DPP method and LAGDPP method. EUV radiation can be achieved by flowing a relatively small current in the discharge area.

Moreover, energy can be input into the plasma efficiently without implementing high-speed short pulsing of discharge current. Accordingly, a discharge current pulse can be set to be long compared with the conventional methods.

(2) EUV radiation lasts as long as a narrow discharge channel continues to exist. Hence, it is possible to make the duration time of the narrow discharge channel longer than that in the conventional methods by making pulse-stretched discharge current by configuring a discharge circuit in such a way that a discharge current pulse becomes longer than that in the conventional DPP method and LAGDPP method. As a result, pulse-stretched EUV radiation can be obtained.

In the present invention, if the duration time of a discharge channel is made at least 1 $\mu$s, a period during which a discharge channel with a current value at or above Ip or at or above Ip2 can exist can be made longer than 200 ns without fail. In other words, it is surely possible to make the duration time of EUV radiation longer than the duration time of conventional EUV radiation (200 ns) by setting the duration time of the discharge channel to not less than 1 $\mu$s.

(3) Discharge current is not necessarily to be high unlike the conventional DPP method and LAGDPP method. It is not necessary to implement the high-speed short pulsing of discharge current, either. Hence, the thermal load placed on the electrodes can be made smaller than that in the conventional methods, whereby the occurrence of debris can be suppressed.

(4) Unlike the conventional long pulsing technology, it is not necessary to flow high current in the discharge space because the waveform of plasma current does not need to be controlled in such a way as to keep high temperature plasma in the pinch state. Neither is there any need to change the waveform of plasma current in order to maintain the pinch effect, which eliminates any sophisticated synchronization control and current control.

(5) The positional stability of the originating point of EUV radiation can be enhanced by irradiating an energy beam for fixing the discharge path to the discharge path (i.e., a discharge channel) in order to fix the discharge path by the energy beam.

Best Mode for Implementing the Invention

A description of the basic configuration according to the present invention is given below. The following explanation includes (1) an example of the basic configuration of an EUV light source device for implementing the method of generating EUV radiation according to the present invention, (2) steps of generating EUV radiation according to the present invention, (3) the irradiation timing of an energy beam (a laser beam), (4) a raw material supply system, (5) an orienting mechanism, (6) the correlation among the position of electrodes, the position of supplying high temperature plasma material and the position of irradiating an energy beam (a laser beam) and (7) energy of an energy beam for vaporizing raw material. Although we use a laser beam as an energy beam for the purpose of explanation, an energy beam could be an electron beam or the like.

(1) Example of the basic configuration of an EUV light source device for implementing the method of generating EUV radiation according to the present invention

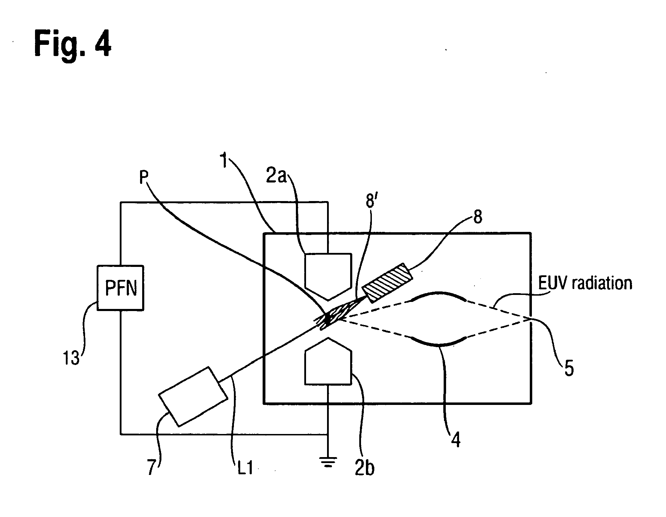

Fig. 4 shows the basic configuration of the EUV light source device according to the present invention.
In the figure, a first electrode 2a and a second electrode 2b are installed within a chamber 1, which is the discharge vessel. The first electrode 2a is the cathode, for example, the second electrode 2b is the anode, and the second electrode 2b is grounded. That is, a high, negative voltage is applied between the electrodes.
The two electrodes are connected to a pulsed power generator 13. The PFN (Pulse Forming Network) circuit type, for example, is adopted for the pulsed power generator 13 in order to run a current with a long pulse width between the two electrodes.

High temperature plasma raw material 8 is set in place in the vicinity of the paired electrodes but outside the discharge region. Metals such as tin (Sn) or lithium (Li) can be used as the high temperature plasma raw material 8. These can be either solid or liquid. Figure 4 shows a schematic example in which the high temperature plasma raw material 8 is a solid metal.

A laser source 7 is used to produce a low temperature plasma (gasified high temperature raw material). A laser beam L1 emitted from the laser source 7 is guided within the chamber 1 and irradiates the solid or liquid high temperature plasma raw material 8. The irradiation energy of the laser is of a level to gasify the solid or liquid high temperature plasma raw material but not to raise the electron temperature much, in a range from $10^5$ W/cm$^2$ to $10^{16}$ W/cm$^2$, for example.

When the laser beam irradiates the high temperature plasma raw material 8, at least a part of the high temperature plasma raw material 8 is gasified and sprayed out as low temperature plasma 8'. By setting the conditions of the irradiating laser beam appropriately, it is possible to have the gasified high temperature raw material (low temperature plasma 8') spray out from the solid, for example, raw material 8 continuously for a period of about 10 $\mu$s.

As stated above, the low temperature plasma is in a state with an ion density of about $10^{17}$ cm$^{-3}$ to $10^{20}$ cm$^{-3}$ and with an electron temperature that does not exceed about 1 eV, constituted so as to be supplied selectively to a discharge channel formed in advance between the electrodes.

Now, the discharge channel is made narrow by the self-magnetic field of the discharge current. The vapor of material that sprays from a solid material or a liquid material because of laser irradiation generally travels while expanding in three dimensions. Therefore, the low temperature plasma gas that sprays out from the high temperature plasma raw material 8 is controlled into a steady flow with good directionality by means of a flow control mechanism, illustration of which has been omitted. Now, the example of the flow-control mechanism is explained later.

(2) EUV generation procedures of this invention

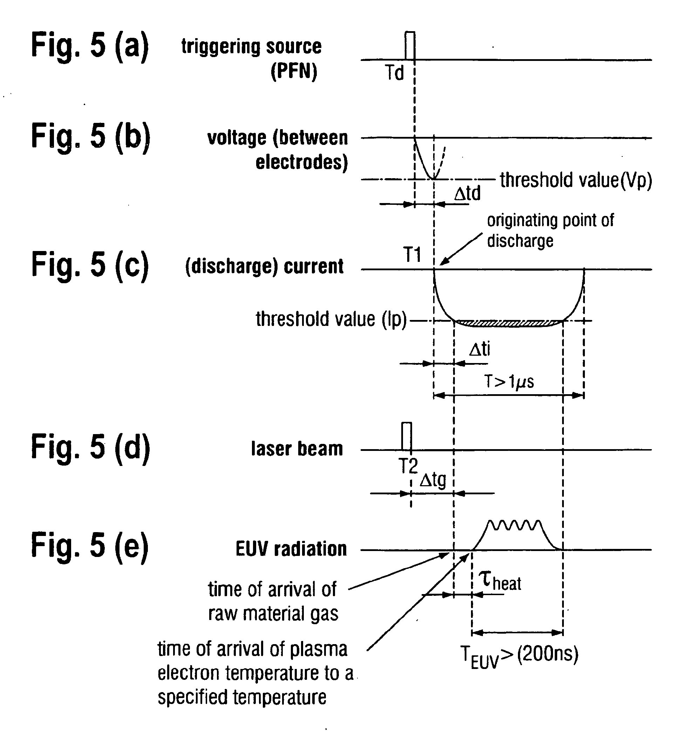

The EUV generation procedures of this invention are explained with reference to the timing chart shown in Figure 5. The multi-pinch method is taken as an example.

First, a trigger signal is input (time Td) to the switching means of the pulsed power supply means (an IGBT, for example) of the pulsed power generator 13 that applies pulsed power between the paired electrodes 2a, 2b (Figure 5(a)), and the switching means is turned ON.

Accompanying that, the inter-electrode voltage rises (Figure 5(b)). Then discharge occurs at the point T1 (= Td + $\Delta$td) when the voltages reaches a threshold value Vp (Figure 5(c)). The discharge is generated by the action of a discharge start-up means, illustration of which has been omitted from Figure 4. The threshold value Vp is the voltage value when the value of the discharge current that flows when discharge is generated is at or above the threshold value Ip (or Ip2 in the case of the non-pinch method). That is, if discharge occurs at less than the threshold value Vp, the peak value of the discharge current will not reach the threshold value Ip or Ip2.

At time point T1 the discharge current begins to flow between the electrodes, and a discharge channel is formed. Then, at the point when $\Delta$ti has elapsed (T1 + $\Delta$ti), the value of the discharge current reaches the threshold value Ip. This threshold value Ip, as noted above, is set so that $P_B$ » $P_p$ (formula (4), stated previously) when $P_B$ is the compression pressure due to the self-magnetic field inherent to the current and $P_p$ is the pressure of the plasma. In other words, it is the current value capable of adequately compressing the low temperature plasma gas by means of the self-magnetic field.

Now, the threshold value Ip is a current value having energy capable of heating low temperature plasma gas (the ion density in the plasma is about $10^{17}$ to $10^{20}$ cm$^{-3}$ and the electron temperature is about 1 eV) to between 20 and 30 eV or more.

At the time (T1 + $\Delta$ti), moreover, the diameter of the discharge channel flowing through the discharge region is sufficiently narrow.

A laser beam irradiates the high temperature plasma raw material located outside the discharge region at or after this time (T1 + $\Delta$ti), so that at least a part of the low temperature plasma gas having an ion density corresponding to EUV emission conditions and a low electron temperature will have reached the narrow discharge channel selectively (Figure 5(d)). Taking the period from the point when the laser beam irradiates the high temperature plasma raw material until at least a part of the low temperature plasma gas reaches the discharge channel as $\Delta$tg, a laser beam irradiates the high temperature plasma raw material at time point T2, which is time point (T1 + $\Delta$ti - $\Delta$tg) or thereafter. Figure 5 shows a case in which the time point T2 = (T1 + $\Delta$ti - $\Delta$tg).

After the period $\tau_{heat}$ which begins at the time point (T1 + $\Delta$ti = T2 + $\Delta$tg), the electron temperature of the low temperature plasma gas reaches 20 eV to 30 eV under the action of the discharge, and it becomes a high temperature plasma; EUV emission from this high temperature plasma begins (Figure 5(e)).

Because low temperature plasma gas with an ion density corresponding to EUV emission conditions and a low electron temperature is supplied continuously to the narrow discharge channel, the pinch effect or the confinement effect of the self-magnetic field occurs repeatedly. Therefore, the diameter of the narrow discharge channel shows a pulsating action, narrowing and broadening, but it is kept in a relatively narrow state. In other words, the pinch effect of the low temperature plasma is repeated and EUV emission continues.

The EUV radiation produced in the discharge region are reflected by the EUV collector optics 4 and released to an unillustrated irradiation area from the EUV extraction area 7.

The period for which EUV emission is maintained under the conventional DPP method or LAGDPP method using the pinch effect is, for example, 200 ns or less. Here, it becomes possible to pulse-stretch the EUV emission relative to the conventional DPP method or LAGDPP method using the pinch effect by setting the discharge circuit, which comprises the pulsed power generator 13 and the paired electrodes (first electrode 2a and second electrode 2b), so that the period for which the discharge channel at the threshold value Ip is maintained continues from the point (T1 + $\Delta$ti = T2 + $\Delta$tg) when a part of the low temperature plasma gas arrives at the narrow discharge channel for (200 ns + $\tau_{heat}$).

Under the conventional DPP method or LAGDPP method using the pinch effect, the duration of the discharge channel is 1 $\mu$s or less, and when the initial plasma is pinched, the duration of the EUV emission (period A in Figure 2 (a)) is 200 ns or less at the longest.

It was learned, as a result of experimental verification by the present inventors, that when the duration of the discharge channel is at least 1 $\mu$s or more, it is possible to reliably prolong the period that the discharge channel continues with a current value at or above Ip or at or above Ip2 beyond 200 ns. That is, when the duration of the discharge channel is set to 1 $\mu$s or more, it is possible to reliably prolong the duration of the EUV emission beyond the conventional EUV emission duration (200 ns)

Now, in the case of the non-pinch method, pulse stretching of the EUV emission will be realized by the same mechanism as described above if the threshold value is set to be Ip2, and so detailed explanation of that is omitted.

In this invention, there is no need to run a large current through the discharge space as in the EUV emission pulse stretching method of WO 2006/101942 A1 and JP-A-2007-123138, in which the plasma current waveform is controlled by maintaining a pinched state. Further, there is no need to change the waveform of the plasma current I shown in Figure 22(a), and so the discharge current (plasma current) waveform in this method has no polarity reversal point.

(3) Irradiation timing of the energy beams (laser beams)

In the EUV generation procedure described above, the timing with which the laser beam irradiates the high temperature plasma raw material is set so that at least a part of the low temperature plasma gas reaches the narrow discharge channel at or after the time when the value of the discharge current has reached the threshold value Ip.

Consider the case in which at least a part of the low temperature plasma gas reaches the narrow discharge channel before the value of the discharge current has reached the threshold value Ip (case A) and the case in which, before the discharge, at least a portion of the low temperature plasma gas reaches the region where the discharge channel is produced after the discharge (case B).

In case A and case B, the low temperature plasma gas cannot be heated sufficiently until the discharge current reaches the threshold value Ip, and as a result, there is an increased proportion of low temperature plasma that does not contribute to EUV radiation and the efficiency of the EUV emission drops.

Further, in case A and case B, until the value of the discharge current reaches the threshold value Ip, the low temperature plasma gas, which is the high temperature plasma raw material provided selectively as a steady flow, expands in the region where the discharge channel is produced after the discharge and its density drops. Accordingly, the density of the high temperature plasma raw material in the discharge region nears the initial conditions of the pinch in Figure 20. In such a state, the diameter of the discharge channel broadens, and so a large current is necessary as the discharge current in order to narrow the discharge channel to make a high temperature plasma.

In case B, in particular, the low temperature plasma is supplied prior to discharge, and so the discharge channel is formed by a gas discharge of the high temperature plasma gas with a reduced density because of expansion, and the diameter of the discharge channel is broader than in case A. Therefore, as well as in the DPP method, fast, short current pulses with high power, to a degree, are required to narrow the discharge channel and make the initial plasma into a high temperature plasma by means of the pinch effect (close to path 2 in Figure 20).

In this invention, as stated above, a discharge circuit is formed to prolong the duration of the discharge channel, and so it is difficult to realize the current pulses that are required in case B.

Therefore, it is important to set the timing of laser beam irradiation of the high temperature plasma raw material so that at least a part of the low temperature plasma gas arrives at the narrow discharge channel at least after discharge has begun (case A) and preferably at or after the point when the value of the discharge current reaches the threshold value Ip, as shown in Figures 5(a) to 5(e).

(4) Raw material supply system

In this invention, as stated above, irradiation of high temperature plasma raw material with a laser beam or other energy beam produces a low temperature plasma gas with an ion density corresponding to EUV emission conditions and a low electron temperature (ion density from $10^{17}$ cm$^{-3}$ to $10^{20}$ cm$^{-3}$; electron temperature not exceeding 1 eV), and supplies that low temperature plasma to the discharge region. Figure 4 shows a schematic example in which the high temperature plasma raw material is a solid metal, but as stated above, it is acceptable for the high temperature plasma raw material to be a liquid.

As an example of the constitution of a raw material supply system that uses a solid high temperature plasma raw material to supply low temperature plasma gas to the discharge region, that shown schematically in Figure 4 is constituted to irradiate with a laser beam a solid metal (Sn, for example) placed in a specified region in the vicinity of the discharge region.

Another example is constituted to use two reels to supply a high temperature plasma raw material formed as a wire to a space from which the low temperature plasma gas formed by laser beam irradiation can reach a specified region and to irradiate that high temperature plasma raw material wire with a laser beam.

As an example, on the other hand, of the constitution of a raw material supply system that uses a liquid high temperature plasma raw material to supply low temperature plasma gas to the discharge channel, there is that constituted so as to put the liquid high temperature plasma raw material into droplet form, to supply it by dropping to a space from which the low temperature plasma gas formed by laser beam irradiation can reach a specified region, and to irradiate that high temperature plasma raw material in the form of droplets with a laser beam when the high temperature plasma raw material in the form of droplets reaches the space noted above.

Now, as an example using a solid high temperature plasma raw material, it is possible to constitute the electrodes themselves of solid high temperature plasma raw material (Li, for example) as described in WO 2006/120942 A1, irradiate the electrodes with the laser beam to create low temperature plasma gas, and supply that low temperature plasma gas to the discharge channel.

The constitution described in JP-A-2007-505460 and corresponding US 2007/0090304 A1 is possible as a further example of the use of a high temperature plasma raw material in liquid form. That is, the electrodes are structured as rotary electrodes, and a heated "metal melt" liquid high temperature plasma raw material is accommodated in containers. Part of the rotary electrodes (the peripheral part) is submerged in the containers that accommodate the liquid high temperature plasma raw material. Then, by rotating the electrodes, the liquid high temperature plasma raw material that adheres to the peripheral surfaces of the electrodes is delivered to the discharge region. Irradiating this transported liquid high temperature plasma raw material with a laser beam produces a low temperature plasma gas, and the low temperature plasma gas is supplied to the discharge channel.

Nevertheless, this constitution is one in which the high temperature plasma raw material is located in the discharge region; producing low temperature plasma gas and supplying it to the discharge region on the basis of such a method is not desirable for the following reasons.

In the case of the constitutions described in JP-A-2007-505460 and corresponding US 2007/0090304 A1 and WO-A-2006/120942, the plasma (or neutral vapor) produced when a laser beam irradiates the electrode surface can be a vehicle to start discharge, Therefore, the supply of low temperature plasma gas is done in advance of the discharge, which increases the proportion of low temperature plasma that does not contribute to EUV radiation, as stated above, and the efficiency of EUV emission drops.

Further, the low temperature plasma gas is provided before discharge, and so gas discharge of high temperature plasma raw material that has expanded and decreased in density causes a discharge channel to form, and the diameter of the discharge channel broadens. Therefore, current with power that is high, to a degree, becomes necessary to narrow the discharge channel and form a high temperature plasma.

Further, in addition to supply by laser beam irradiation, the supply of low temperature plasma gas to the discharge channel can be done by vaporizing the electrode itself (or a liquid high temperature plasma raw material adhered to the electrode) by raising the temperature of the electrode by means of the drive current that accompanies advancement of the electrode.

Accordingly, the parameters of the low temperature plasma gas change from moment to moment depending on the discharge current, and the output of EUV radiation fluctuates. Because of fluctuation of the discharge channel during discharge, moreover, the position of the high temperature plasma fluctuates and the apparent size of the high temperature plasma increases.

These drawbacks come about because the high temperature plasma raw material and the electrode are united and the supply of low temperature plasma gas depends on both the laser beam irradiation and the discharge current (plasma current).

In this invention, therefore, the high temperature plasma raw material and the electrode are separate and the supply of low temperature plasma gas depends on laser beam irradiation only; it is independent of the discharge current. In other words, the raw material supply system is constituted so that control of the supply of low temperature plasma gas and control of the drive current that flows between the electrodes are mutually independent, as in the example of constitution shown in Figure 4 and other examples of constitution (wire and droplet forms) discussed previously.

(5) Flow-control mechanism

The low temperature plasma gas, as stated above, is constituted so that it is supplied selectively to the discharge channel that is narrowed by the self-magnetic field after the discharge is generated. Normally the material vapor sprayed out from the solid material or liquid material by laser beam irradiation travels while expanding in three dimensions. Therefore, when the low temperature plasma gas is made to spray out by laser beam irradiation of a solid or liquid high temperature plasma raw material, a flow with good directionality is constituted by means of flow control of the flow of spraying low temperature plasma gas, and the flow is set to be supplied continuously, concentrated on the narrow discharge channel vicinity.

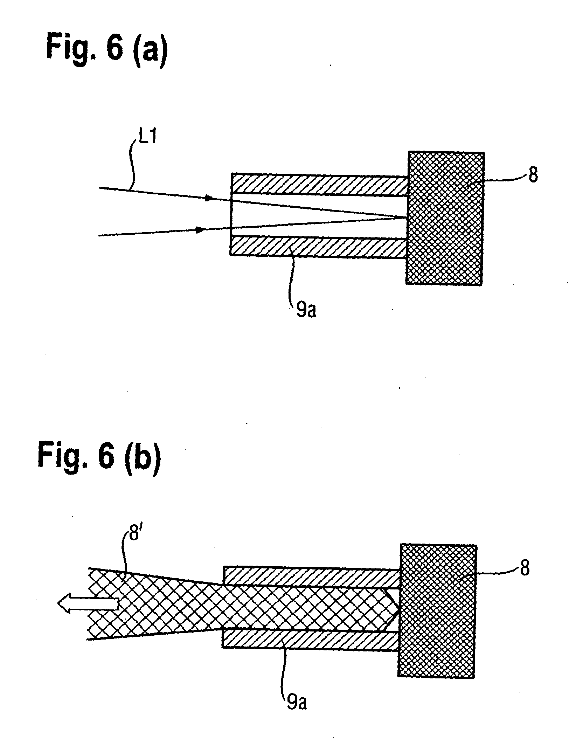

Figs. 6(a) & 6(b) show an example in which a tubular nozzle is installed for spraying out material at a position where a laser beam irradiates the high temperature plasma material. As shown in Fig. 6(a), a laser beam L1 passes through the through hole of a tubular nozzle 9a. After the laser beam passes through the tubular nozzle 9a to irradiate the high temperature plasma material 8, the high temperature plasma material 8 is vaporized to generate low temperature plasma gas 8'.

As shown in Fig. 6(b), the low temperature plasma gas 8' passes through, and is sprayed out of, the tubular nozzle 9a.

The low temperature plasma gas 8' sprayed out of the tubular nozzle 9a is restricted in its spraying angle by the tubular nozzle 9a, which allows selectively supplying a flow of low temperature plasma gas having a good directionality to a discharge channel continuously.

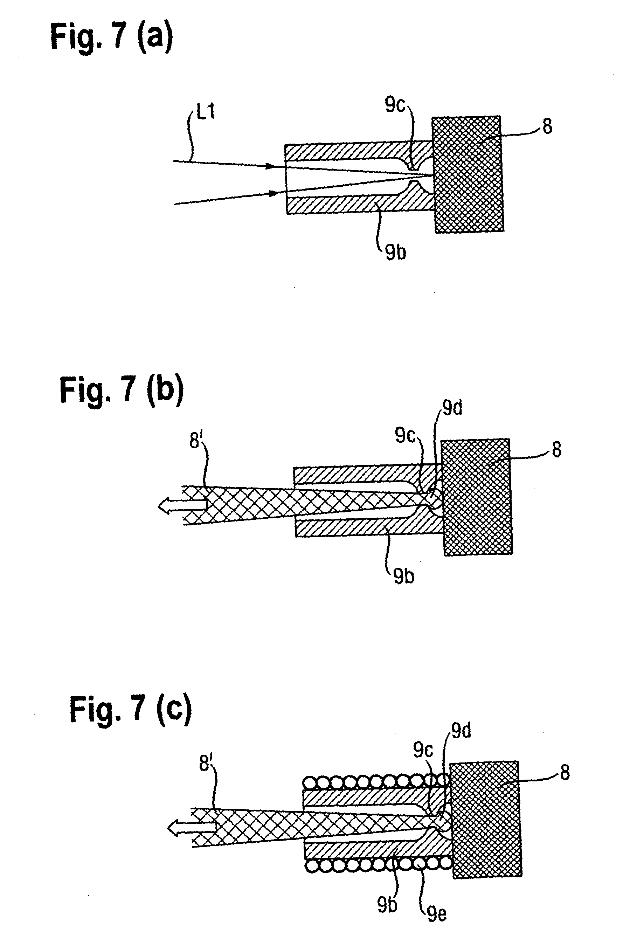

The shape of the tubular nozzle is not limited to that of a straight pipe as shown in Fig. 6(a). As schematically shown in Figs. 7(a)-7(c), it may be the shape of a nozzle provided with a constricted area 9c on a section inside the nozzle for issuing a high-speed jet 9b.

As shown in Fig. 7(a), a laser beam L1 passes through the through hole of the high-speed jet nozzle 9b. After the laser beam passes through the high-speed jet nozzle 9b to irradiate the high temperature plasma material 8, the high temperature plasma material 8 is vaporized to generate low temperature plasma gas 8'.

Since the constricted area 9c is provided inside the high-speed jet nozzle 9b, pressure abruptly increases with the low temperature plasma gas 8' inside the space between the constricted area 9c and the portion of high temperature plasma material 8 irradiated by the laser beam L1 (i.e., the pressure rising section 9d in Fig. 7(b)). As shown in Fig. 7 (b), the low temperature plasma gas 8' is accelerated and sprayed out of the opening of the constricted area 9c as a high-speed gas flow having a good directionality.

Here, the spraying direction of the high-speed gas flow depends on the direction of the high-speed jet nozzle 9b. That is, the traveling direction of vaporized material does not depend on the incident direction of the laser beam to high temperature plasma material.

Since the opening of the constricted area is small in cross section area, high temperature plasma material 8 may be solidified if a laser beam is not irradiated to the high temperature plasma material for an extended period, resulting in obstruction of the opening. Therefore, as shown in Fig. 7(c), the high-speed jet nozzle 9b may be heated by a heater 9e or the like so as to prevent solidification of the high temperature plasma material inside of the high-speed jet nozzle 9b.

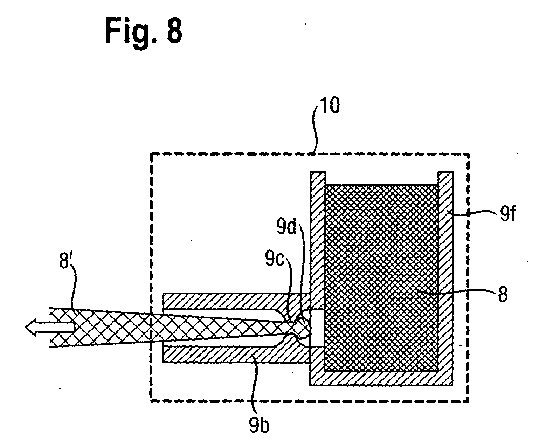

The closer the tubular nozzle 9a and high-speed jet nozzle 9b are to the high temperature plasma material 8, the more effective they are. Specifically, since the high-speed jet nozzle 9b needs to be provided with a pressure rising section 9d, it is desirable that the space inside the high-speed jet nozzle 9b, between the constricted area 9c and the portion of high temperature plasma material 8 irradiated by the laser beam L1, is as air tight as possible. For example, as shown in Fig. 8, it is desirable to use a raw material supply unit 10 in which a raw material containing section 9f, which contains high temperature plasma material 8, and a high-speed jet nozzle 9b are integrally configured.

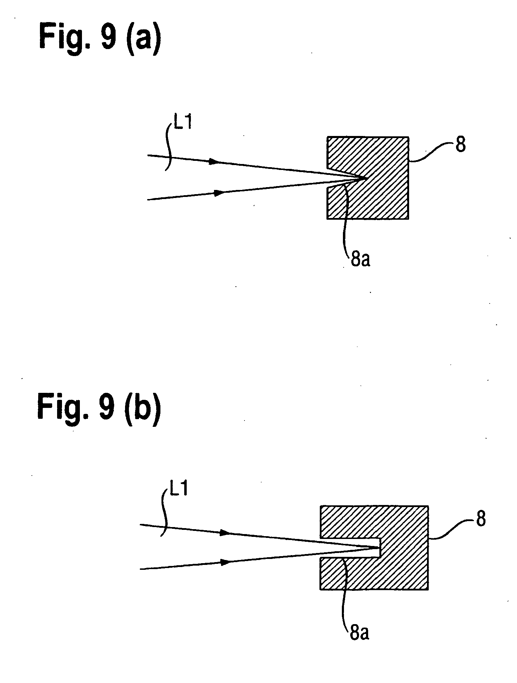

The orienting mechanism is not limited to the aforementioned example. As shown in Figs. 9(a) and 9(b), for example, a concavity 8a may be formed in advance in a position of the high temperature solid plasma material that is to be irradiated with the laser beam L1.

After laser beam L1 irradiated the concavity 8a of the high temperature plasma material 8, the high temperature plasma material 8 is vaporized to generate low temperature plasma gas 8'. Here, the spraying angle of the low temperature plasma gas sprayed out of the concavity 8a is restricted by the wall of the concavity 8a, which allows selectively supplying of a flow of low temperature plasma gas having a good directionality to a discharge channel continuously.

(6) The correlation of the positions of the electrodes, the high temperature plasma material and the irradiating energy beam (laser beam)

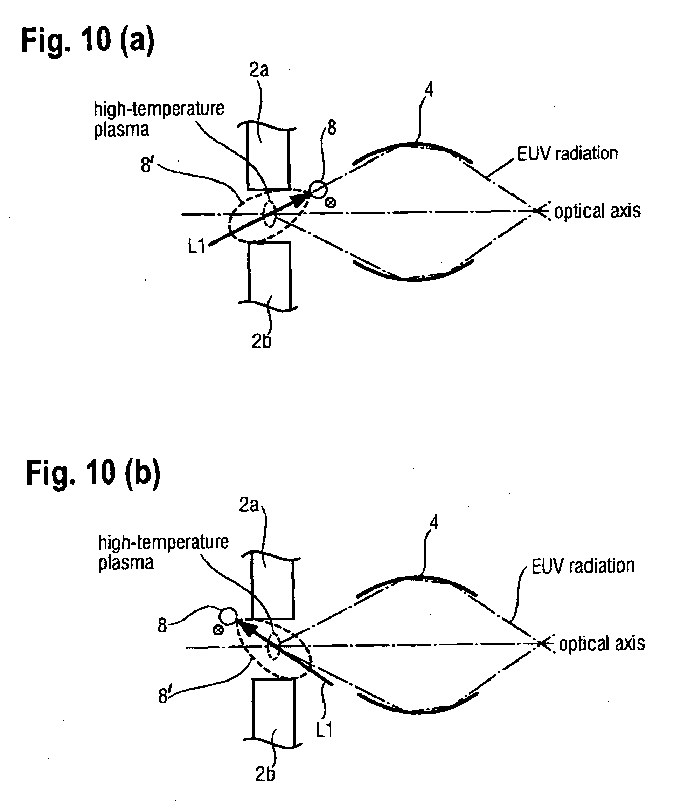

In the present invention, as described above, low temperature plasma gas reaches a discharge channel by a laser beam. Fig. 10 shows an example of its positional relationship.

Fig. 10 is a schematic view for explaining the aforementioned positional relationship. In order to make the explanation easier, high temperature plasma material 8 is schematically shown as a circle, and an orienting mechanism

**EP 2 046 100 B1**

is omitted.

In Fig. 10, a pair of plate-shaped electrodes 2a, 2b is arranged at a specified interval. A discharge channel is provided in a discharge area inside the space between the electrode 2a, 2b. Low temperature plasma gas 8', generated due to vaporization of high temperature plasma material 8 by irradiation with a laser beam L1, spreads in the incident direction of the laser beam. Thus, by irradiating the face opposite to the discharge area of high temperature plasma material 8 with the laser beam L1, low temperature plasma gas 8' can be supplied to a discharge channel provided in the discharge area.

On the beam exit side of the aforementioned electrodes 2a, 2b is placed EUV radiation collector optics 4. As the collector optics 4, a grazing incidence optical system is often used for setting the radiation collection direction so that the optical axis can be set in one direction. In general, EUV radiation collector optics used for such a grazing incidence optical system are formed by arranging a plurality of nested thin concave mirrors with high precision.

The aforementioned multiple thin concave mirrors of the EUV radiation collector optics having the aforementioned configuration are supported by a column support, which substantially agrees with the optical axis, and support body, which are radially extended from the column support.

Here, part of the low temperature plasma gas supplied to the discharge channel by irradiation with a laser beam, which does not contribute to the formation of high temperature plasma, or part of a cluster of atomic gas generated by decomposition as a result of the formation of high temperature plasma contacts and is accumulated on the low temperature portions of the EUV light source device as debris. As an example, if the high temperature plasma material is Sn, part of which did not contribute to the formation of low temperature plasma or part of a metal cluster such as Sn and $Sn_X$ in the atomic gaseous state generated by decomposition as a result of the formation of plasma contacts the low temperature portions of the EUV light source device as debris to give a tin mirror.

As shown in Fig. 10(b), if high temperature plasma material 8 is supplied in the space on the opposite side of the EUV radiation collector optics 4 relative to the pair of electrodes 2a, 2b, the laser beam L1 irradiates the high temperature plasma material 8 from the side of the EUV radiation collector optics 4 so that low temperature plasma gas 8' can be supplied to the discharge channel. In this case, low temperature plasma gas 8' generated by the irradiation of the laser beam L1 spreads in the direction of the discharge channel and the EUV radiation collector optics 4. In other words, debris is released towards the EUV radiation collector optics 4 as a result of the irradiation of the high temperature plasma material 8 by the laser beam L1 and electric discharge generated between the electrodes 2a, 2b. In consequence, the accumulation of debris on the EUV radiation collector optics 4 decreases the reflectivity of the EUV radiation collector optics 4 at 13.5 nm, resulting in the deterioration of the performance of the EUV light source device. Accordingly, it is preferred to place high temperature plasma material 8 in the space between the pair of electrodes 2a, 2b and the EUV radiation collector optics 4 in the vicinity of the discharge area, as shown in Fig. 10(a).

The laser beam L1 is radiated onto the surface of the high temperature plasma material arranged as described above on the side facing the discharge area. As a result, low temperature plasma gas 8' does not spread in the direction of the EUV radiation collector optics 4 but spreads towards the discharge area. That is, it is possible to prevent debris from advancing toward the EUV radiation collector optics 4 by setting the position of the high temperature plasma material 8 and the irradiation position of the laser beam L1 as described above.

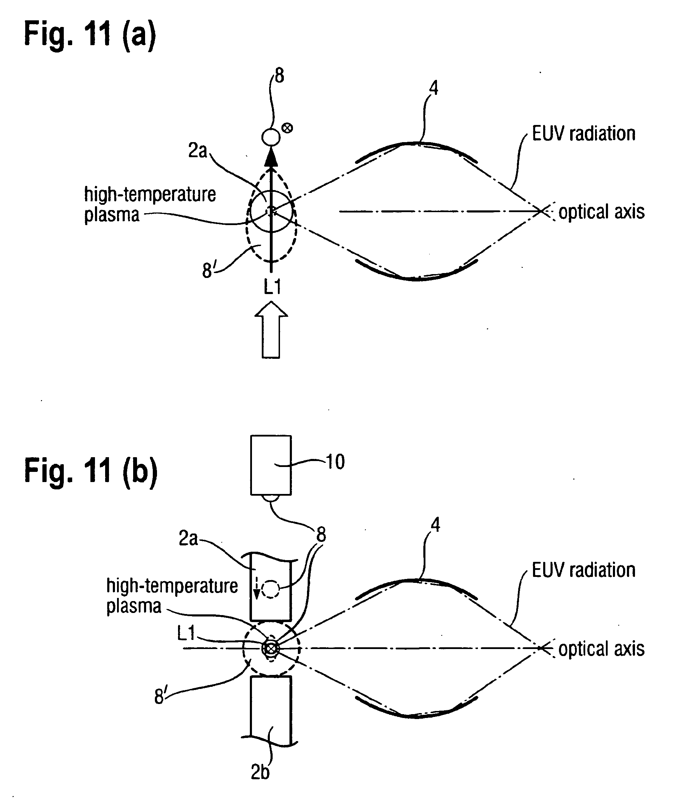

Here, let us consider the case in which a pair of electrodes 2a, 2b separated at a specified interval is column shaped as shown in Figs. 11(a) & 11 (b), which are top and front views, respectively. In this case, if high temperature plasma material 8 is placed in the space on the plane perpendicular to the optical axis in the vicinity of a discharge area and a laser beam L1 irradiates the high temperature plasma material 8 from the direction perpendicular to the optical axis, low temperature plasma gas 8' does not spread toward the EUV radiation collector optics 4. Accordingly, debris generated by the irradiation of the high temperature plasma material 8 by the laser beam L1 and electric discharge formed between the electrodes 2a, 2b hardly advances in the direction of the EUV radiation collector optics 4.

Needless to say, in the case that a pair of electrodes 2a, 2b separated at a specified interval is column shaped, high temperature plasma material 8 may be placed in the space between the electrodes 2a, 2b and the EUV radiation collector optics in the vicinity of a discharge area.

(7) Energy of an energy beam for vaporizing material

The time $\Delta tg$ between the point of time at which a laser beam is irradiated to the high temperature plasma material and the point of time at which at least part of the low temperature plasma gas reaches the discharge channel is found using the distance between the discharge channel and the high temperature plasma material irradiated by the laser beam and the speed of spreading of low temperature plasma gas. Here, the distance between the discharge channel and the high temperature plasma material irradiated by the laser beam depends on the position of the discharge channel and high temperature plasma material at the time of the irradiation with the laser beam and the direction of the laser beam irradiated to the high temperature plasma material.

As described above, low temperature plasma gas generated by irradiation with a laser beam spreads at a

17

specified speed in the incident direction of the laser beam. The aforementioned specified speed depends on the energy of the laser beam irradiated to the high temperature plasma material. That is, the time Δtg between the point of time at which a laser beam is irradiated to high temperature plasma material and the point of time at which at least part of the low temperature plasma gas reaches the discharge channel depends on the position of the discharge channel and high temperature plasma material, the direction of the laser beam irradiated to the high temperature plasma material and the energy of the laser beam, and therefore, can be set to a specified time by properly setting these parameters.

As explained above, in the EUV generating method of this invention, a narrow discharge channel is formed in the discharge region in advance and a steady flow of low temperature plasma gas with an ion density corresponding to EUV emission conditions and a low electron temperature (ion density from $10^{17}$ cm$^{-3}$ to $10^{20}$ cm$^{-3}$; electron temperature not exceeding 1 eV) is selectively supplied to the narrow discharge channel from outside the discharge region.

The timing of the supply of low temperature plasma gas here is set so that the low temperature plasma gas (ion density from $10^{17}$ to $10^{20}$ cm$^{-3}$; electron temperature not exceeding 1 eV) arrives at the narrow discharge channel at or after the point when the value of the discharge current reaches the threshold value (Ip or Ip2). As a result, the discharge acts on the low temperature plasma gas and, passing through path II of figure 1, high temperature plasma that fulfills the EUV emission conditions is formed and EUV radiation is produced.

Here, low temperature plasma gas is supplied to the discharge channel and EUV radiation are realized through path (II) of figure 1, and so a large discharge current is not necessary as in the conventional DPP method and the LAGDPP method; EUV emission is made possible by running a relatively small current through the discharge region. It is possible, moreover, to input energy into the plasma efficiently, without implementing fast and short pulses of discharge current as in the prior art. Therefore, discharge current pulses can be set longer than in the prior art.

The EUV emission continues while a discharge channel that is narrow, to some degree, is maintained. Therefore, by constituting the discharge circuit so that discharge current pulses are longer than in the conventional DPP method or LAGDPP method and pulse stretching the discharge current pulses, it is possible to prolong the duration of the narrow discharge channel relative to the prior art, and longer pulses of EUV emission can be realized as a result.

In the multi-pinch method, the threshold value Ip is set so that $P_B \gg P_p$ as expressed in formula (4) above, when $P_B$ is the compression pressure due to the self-magnetic field inherent to the current and $P_p$ is the pressure of the plasma. In other words, the threshold value Ip is the current value at which adequate compression of the low temperature plasma gas by the self-magnetic field is possible. Now, the threshold value Ip is the current value that has energy capable of heating the electron temperature of the low temperature plasma gas to between 20 eV and 30 eV or more. Here, the diameter of the discharge channel that runs through the discharge region is narrowed sufficiently at the point when the value of the discharge current becomes Ip.

Supplying low temperature plasma to the narrow discharge channel continuously enables repetition of the pinch effect or the confinement effect of the self-magnetic field. At this time the diameter of the narrow discharge channel narrows and broadens in a pulsating action, but it is maintained in a relatively narrow state. This sort of repetition of the pinch effect or the confinement effect of the self-magnetic field sustains the period that the discharge current continues.

In this invention, as described above, the discharge current pulse can be set longer than in the prior art and it is possible to maintain a continuous pinch effect or confinement effect of the self-magnetic field for a long period, and so it is possible to realize pulse stretching of the EUV emission (multi-pinch method).

In the non-pinch method, moreover, the threshold value Ip2 is set to $P_B \gtrapprox P_p$, as represented in formula (5) above. In other words, Ip2 is the current value that compresses the low temperature plasma gas weakly (at a level where the low temperature plasma does not lose ion density by expanding). Now, the threshold value Ip2 described above is the value of current that has energy capable of heating the low temperature plasma gas to an electron temperature of 20 eV to 30 eV or more. Here, the diameter of the discharge channel through the discharge region is narrowed at the point when the discharge current reaches Ip2. As a result of supplying low temperature plasma gas to the narrow discharge channel continuously, the low temperature plasma gas is heated while being maintained at a level where it does not lose ion density by expanding and becomes a high temperature plasma, and EUV is emitted by this high temperature plasma.

This heating of low temperature plasma gas, while maintaining its ion density, is sustained as long as the discharge current continues. In this invention, as stated above, the discharge current pulse can be set longer than in the prior art and the plasma temperature and density necessary for EUV emission can be maintained for a long period by heating the low temperature plasma, and so it is possible to realize pulse stretching of the EUV emission (non-pinch method).

Now, the diameter of the discharge channel is greater in the non-pinch method than in the multi-pinch method, and so the size of the high temperature plasma is also greater than in the multi-pinch method. It was learned, as a result of experimental verification by the present inventors, that when the duration of the discharge channel is at least 1 μs or more, it is possible to reliably prolong the period that the discharge channel continues with a current value at or above Ip or at or above Ip2 beyond 200 ns. That is, when the duration of the discharge channel is set to 1 μs or more, it is possible to reliably prolong the duration of the EUV emission beyond the conventional EUV emission duration (200 ns)

There is no need, as stated above, for the large current or the fast and short pulses of discharge current seen in the conventional DDP and LAGDPP methods. Consequently, it is possible to reduce the thermal load on the electrodes relative to that of the prior art, and it becomes possible to suppress the occurrence of debris.

In this invention, moreover, there is no need to control the plasma current waveform in order to maintain the pinch effect of high temperature plasma, as in the pulse stretching technology of the prior art, and so there is no need to run a large current through the discharge space. Further, there is no need to change the waveform of the plasma current, and so highly precise current control is unnecessary. In other words, the discharge current (plasma current) waveform in this method has no polarity reversal point.

Further, it is preferable to constitute the raw material supply system so that control of the supply of low temperature plasma and control of the drive current between the electrodes are mutually independent. With such a constitution, the supply of low temperature plasma is unaffected by the discharge current (plasma current), and so EUV emission stability is improved.

Moreover, it is desirable to place (or supply) the high temperature plasma raw material between the paired electrodes and the EUV collector optics and to irradiate the laser beam toward the surface of the high temperature plasma raw material on the side that faces the discharge region. When this is done, the low temperature plasma gas will spread in the direction of the discharge region, but it will not spread in the direction of the EUV collector optics. Therefore, it becomes possible to inhibit the travel of debris toward the EUV collector optics.

A description of the specific configuration of the EUV light source device according to the present invention is given below.

(1) Embodiment 1

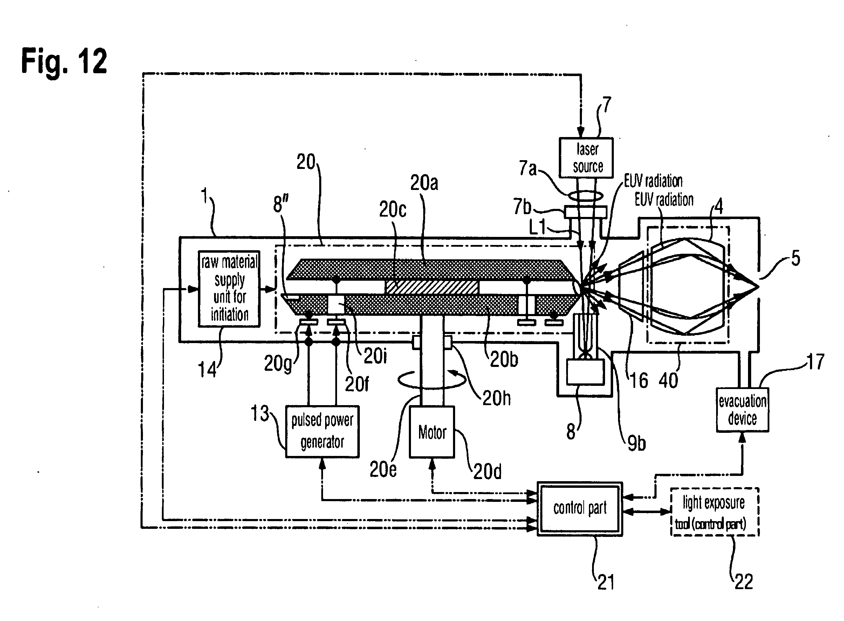

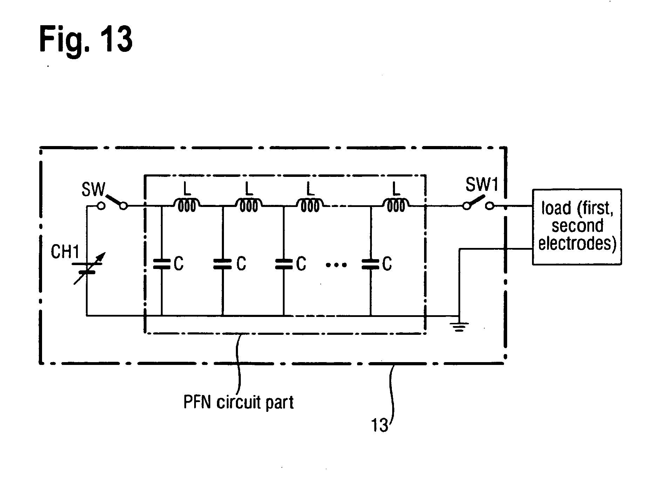

Figs. 12 & 13 show the configuration of Embodiment 1 for an EUV light source device using the method for generating extreme ultraviolet (EUV) radiation according to the present invention.. Fig 12 is the schematic configuration of the aforementioned EUV light source device. EUV radiation is extracted on the right side of the drawing. Fig. 13 shows the configuration of the power supply means in Fig. 12.

The EUV light source device in Fig. 12 has a chamber 1, which is a discharge vessel. The chamber 1 comprises a discharge space 20 for generating high temperature plasma by inputting power into the aforementioned low temperature plasma gas and EUV radiation collection space 40 for collecting EUV radiation emitted from the high temperature plasma and guiding it to the irradiation optical system of a lithography tool (not shown here) through an EUV radiation extraction part 5 provided in the chamber 1. The chamber 1 is connected to an evacuation device 17. The evacuation device 17 is used for evacuating the inside of the chamber 1. A description of each part is given below.

(a) Discharge area

The discharge area 1a comprises a first discharge electrode which is a metal disk, a second discharge electrode 20b which is similarly a metal disk, and an insulator 20c sandwiched between them. The center of the first discharge electrode 20a and the center of the second discharge electrode 20b are placed on roughly the same axis, and the first discharge electrode 20a and the second discharge electrode 20b are fixed in positions separated by the thickness of the insulator 20c. Here, the diameter of the second discharge electrode 20b is larger than the diameter of the first discharge electrode 20a. Now, the first discharge electrode 20a and the second discharge electrode 20b rotate, and so they are called rotary electrodes hereafter.

The second discharge electrode 20b is fitted to the rotor shaft 20e of a motor 20d. Here, the second discharge electrode 20b is fitted to the rotor shaft 20e so that the center of the first discharge electrode 20a and the center of the second discharge electrode 20b are positioned on roughly the central axis of the rotor shaft 20e.

The rotor shaft 20e is introduced into the chamber 1 by way of a mechanical seal 20h, for example. The mechanical seal 22h allows the rotor shaft 20e to rotate while maintaining a reduced-pressure in the chamber 1.

A first wiper 20f and a second wiper 20g, constituted of carbon brushes, for example, are fitted to the under side of the second discharge electrode 20b. The second wiper 20g is electrically connected to the second discharge electrode 20b. The first wiper 20f, on the other hand, is electrically connected to the first discharge electrode 20a by way of through holes 20i that penetrate the second discharge electrode 20b.

Now, an insulation mechanism, illustration of which has been omitted, is constituted to prevent dielectric breakdown between the second discharge electrode 20b and the first wiper 20f that is electrically connected to the first discharge electrode 20a. The first wiper 20f and the second wiper 20g are electrical contacts that maintain electrical connection while wiping, and are connected to the pulsed power generator 13. The pulsed power generator 13 supplies power, by way of the first wiper 20f and the second wiper 20g, between the first discharge electrode 20a and the second discharge electrode 20b. That is, even though operation of the motor 20d rotates the first discharge electrode 20a and the second discharge electrode 20b, power from the pulsed power generator 13 is applied, by way of the first wiper 20f and the second wiper 20g, between the first discharge electrode 20a and the second discharge electrode 20b.

The pulsed power generator 13, as shown in Figure 12, includes a PFN circuit area and applies pulsed power with a relatively long pulse width, for example, between the first discharge electrode 20a and the second discharge electrode 20b which are the load. Now, the wiring between the pulsed power generator 13 and the first wiper 20f and the second wiper 20g goes through insulated current introduction terminals, illustration of which has been omitted. The current introduction terminals are fitted to the chamber 1 and enable electrical connection from the power supply means to the first wiper 20f and the second wiper 20g while maintaining a reduced-pressure atmosphere in chamber 1.

The peripheral portions of the first discharge electrode 20a and the second discharge electrode 20b, which are metal disks, are constituted with an edge shape. As shown hereafter, when power is applied to the first discharge electrode 20a and the second discharge electrode 20b by the pulsed power generator 13, a discharge is generated between the edge-shaped portions of the electrodes. As the discharge grows, the electrodes attain a high temperature, and so the first discharge electrode 20a and the second discharge electrode 20b are made of a metal with a high melting point, such as tungsten, molybdenum or tantalum. Moreover, the insulator 20c is made of something such as silicon nitride, aluminum nitride, or diamond.

When a discharge to produce EUV radiation is generated, the first and second discharge electrodes 20a, 20b are rotated. By this means, the position on the electrodes where the discharge is generated changes with each pulse. Therefore, the thermal load imposed on the first and second discharge electrodes 20a, 20b can be made smaller, the speed of discharge electrode wear can be reduced, and the service life of the discharge electrodes can be prolonged.

In order to form the discharge channel in a discharge area in advance, a vacuum arc discharge is generated between the electrodes. For this reason, solid Sn or solid Li is supplied to the discharge electrode 20b as initiation material in order to generate the vacuum arc discharge. The raw material (i.e., solid Sn or solid Li) may be placed in a groove section in advance. Or, as shown in Fig. 12, it may be supplied from a raw material supply unit 14 for initiation. Here, the raw material for initiation hardly contributes to EUV radiation but is used only for generating a discharge between the electrodes in order to form a narrow discharge channel.

As described in Japanese Patent Application Publication No.2007-505460 corresponding to U.S. Patent Application Publication No. 2007/090304, if a raw material supply unit is used, the raw material supply unit may be configured in such a way that Sn or Li (i.e., initiation material) is liquefied by heating and that the groove section of the discharge electrode 20b passes through the liquefied material. In this case, the EUV light source device has a raw material supply unit on the lower side and an EUV radiation extraction part on the upper side. That is, the EUV light source device has a configuration of the EUV light source device in Fig. 12 rotated by 90 degrees counterclockwise.

Or, the raw material supply unit may be configured in such a way that solid Sn or Li is supplied to the groove section of the discharge electrode 20b on a regular basis.

Sn or Li placed on or supplied to the groove section of the discharge electrode 20b is transported toward the EUV radiation extraction space 40 (i.e., the EUV radiation emission side of the discharge space 20) by the rotation of the second discharge electrode 20b.

(b) Power supply means

Figure 13 shows an example of the equivalent circuit of the pulsed power generator 13. The equivalent circuit of the pulsed power generator 13 shown in Figure 13 comprises a charger CH1, a solid switch SW, a PFN circuit area with an LC distributed parameter circuit with n stages of a capacitor C and a coil L in a cascade connection, and a switch SW1. The example of operation of the power supply means is as follows. First, the charging voltage of the charger CH1 is adjusted to a set value Vin. Thus, when the solid switch SW is turned ON, the n capacitors C of the PFN circuit are charged, and a voltage is applied between the first main discharge electrode and the second main discharge electrode when the switch SW1 is turned ON. Thereafter, current flows between the electrodes when a discharge occurs between the electrodes. Here, the circuit loops formed by the individual capacitors C and the load have differing individual impedances, and so the cycles of current flowing in the individual circuit loops differ from one another. The currents that flow in individual circuit loops overlap, and there is a current pulse with a long pulse width between the electrodes as a result.

(c) Low temperature plasma gas supply means

In Figure 12, the means for supplying low temperature plasma gas comprises high temperature plasma raw material 8, a laser source 7 that irradiates this high temperature plasma raw material 8 with a laser beam L1, and a high-speed jet nozzle 9b that is the flow-control means that controls a steady flow of low temperature plasma gas spraying from the high temperature plasma raw material with good directionality.

The high temperature plasma raw material 8 is located in a space on a plane that is roughly perpendicular to the optical axis of the EUV collector optics 4, and in the vicinity of the discharge region between the first discharge electrode 20a and the second discharge electrode 20b. Placement of the high-speed jet nozzle 9b is set so that the low temperature plasma gas sprayed from the nozzle is provided selectively to the region where a narrow discharge channel is produced in the discharge region. Because of such placement of the high temperature plasma raw material 8 and the high-speed jet nozzle 9b, the low temperature plasma gas provided to the discharge channel does not spread in the direction of the EUV collector optics 4. Therefore, hardly any debris produced by laser beam L1 irradiation of the high temperature plasma raw material 8 and by discharge generated between the electrodes travels toward the EUV collector optics 4.

The high-speed jet nozzle 9b is a tubular piece with a constriction inside, as shown in Figure 7(a). When the laser beam L1 that passes into the high-speed jet nozzle irradiates the high temperature plasma raw material 8, the high temperature plasma raw material 8 is gasified and low temperature plasma gas is produced. Here, the constriction is fitted inside the high-speed jet nozzle 9b, and so when the space between the constriction and the portion of the high temperature plasma raw material irradiated by the laser beam, there is a sharp increase in pressure because of the low temperature plasma gas. Thus, the low temperature plasma gas is accelerated by the opening of the constriction and is sprayed out as a high-speed gas flow with good directionality. Here, the spray direction of the high-speed gas flow depends on the direction of the high-speed jet nozzle. That is, the direction of travel of the gasified raw material does not depend on the direction of laser beam incidence on the high temperature plasma raw material.

The laser beam L1 from the laser source 7 is incident on the high temperature plasma raw material by way of a collection means 7a and an incidence window 7b fitted in the chamber 1.

Here, the laser beam L1 is aligned in such a way that part of the laser beam is irradiated to the raw material for initiation supplied to the second discharge electrode 20b and the remaining part of the laser beam is irradiated to the high temperature plasma material 8. As described above, the diameter of the second discharge electrode 20b is larger than that of the first discharge electrode 20a. The laser beam L1 can therefore be aligned in such a way with ease as to pass through the side face of the first discharge electrode 20a and be irradiated to the raw material for initiation supplied to the second discharge electrode 20b. The reason why part of the laser beam L1 irradiates the raw material for initiation is to start electric discharge between the electrodes to form a narrow discharge channel.

A voltage is applied between the first main discharge electrode 20a and the second main discharge electrode 20b from the pulsed power generator 13, and the laser beam L1 irradiates the raw material 8" for initiation supplied to the second electrode 20b at a time when the voltage between the electrodes reaches a threshold value $V_p$ (Td + $\Delta$td in Fig. 5). As a result, the raw material 8" for initiation is vaporized, current starts flowing between the electrodes and then electric discharge occurs. The raw material 8" for initiation is heated and vaporized by the current flowing between the electrodes to become plasma. As the discharge current between the electrodes increases, the discharge channel generated in the discharge space becomes narrow under the influence of the self-magnetic field of the aforementioned discharge current. In other words, part of the laser beam L1 irradiating the raw material 8" for initiation acts as a discharge initiation means (i.e., a laser trigger means) and contributes to the generation of the narrow discharge channel.

In the aforementioned configuration, the laser beam L1 act as a functional element of a discharge initiation means (i.e., a laser trigger means) and a low temperature plasma supply means.

(d) EUV radiation collector part

The EUV emission from the discharge space 20 is collected by grazing-incidence-type EUV collector optics 4 in the EUV emission collection space 40, and is guided to the illumination optical system of lithography tool, illustration of which has been omitted, from the EUV extraction area 5 in the chamber 1.

The EUV collector optics 4 have multiple mirrors that are ellipsoids of revolution or paraboloids of revolution of different diameters, for example. These mirrors are located on the same axis, with their central axes of revolution overlapping so that their focal points are in approximately the same position; their smooth reflective surfaces have nickel (Ni), for example, as the base material, coated with a fine metallic film of ruthenium (Ru), molybdenum (Mo) or rhodium (Rh), and they can reflect EUV radiation well at a grazing incidence from 0° to 25°.

Now, the discharge space 20 is shown as larger than the EUV radiation collection space 40 in Figure 12, but that is for ease of understanding; the actual size relationship is not shown in Figure 12. In reality, the EUV radiation collection space 40 is larger than the discharge space 20.

(e) Debris trap

A debris trap, which captures debris such as metal powder produced by spattering of the peripheral portions of the first and second discharge electrodes 20a, 20b by the high temperature plasma and debris from the Sn or Li radiating species and which allows only the EUV radiation to pass through, is located between the discharge space 20 and the EUV radiation collection space 40 in order to prevent damage to the EUV collector optics 4.

In the EUV light source device shown in Figure 12, a foil trap 16 is adopted as the debris trap. The foil trap 16 is, for example, what is described as a "foil-trap" in U.S. Patent 6,359,969. So that the foil trap will not block EUV emitted from the high temperature plasma, the foil trap comprises multiple plates placed in the radial direction of the region where high temperature plasma is generated and ring-shaped supports that support these plates. The foil trap 16 is installed between the discharge space 20 and the EUV collector optics 4. Pressure within the foil trap is increased over that of the surrounding atmosphere, and so debris that passes through the foil trap loses kinetic energy due to the effect of that pressure. Therefore, it is possible to reduce damage to the EUV collector optics by reducing the energy of debris that collides with the EUV collector optics.

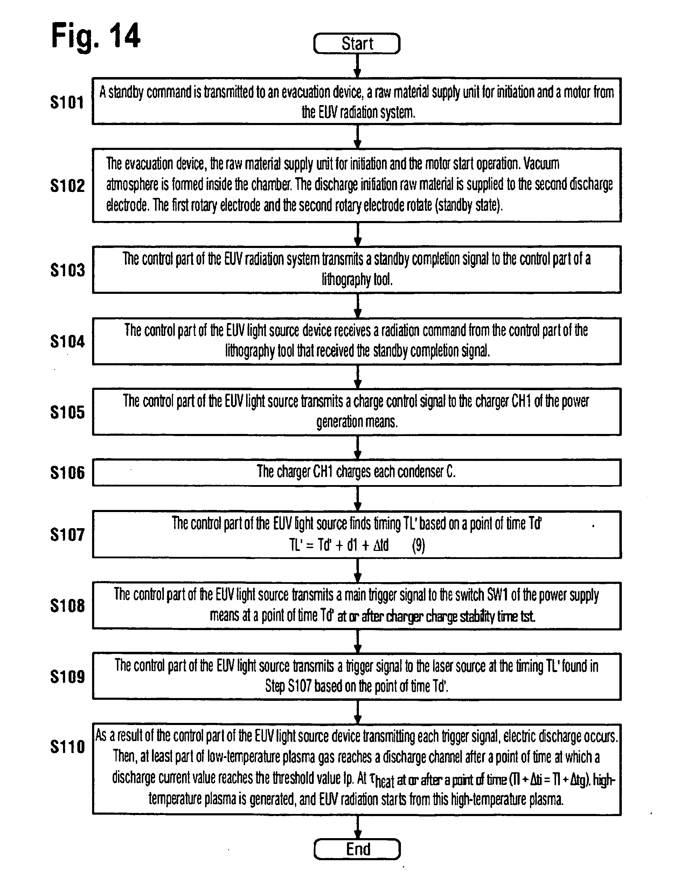

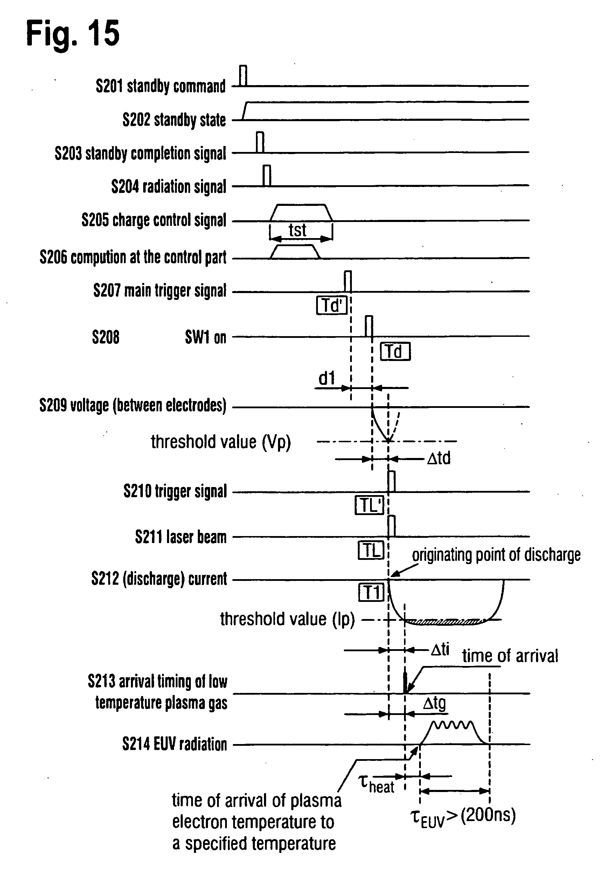

The action of the EUV light source device is explained below with reference to figures 14 and 15. The multi-pinch method is used in this example.

The controller 21 of the EUV light source device has stored the time data $\Delta td$.

$\Delta td$ is the period from the point (Td) when a trigger signal is input to SW1, which is the switching means of the pulsed power generator 13, until the switching means is in an ON state and the inter-electrode voltage reaches the threshold value Vp. Generally speaking, the larger the voltage V applied to the discharge electrodes 20a, 20b is, the more quickly the voltage waveform between the discharge electrodes 20a, 20b rises. Therefore, $\Delta td$ depends on the voltage V applied to the discharge electrodes 20a, 20b. The controller 21 of the EUV light source device has the relationship between the voltage V and $\Delta td$, as determined experimentally beforehand, stored in a table.

The controller 21 also has stored the delay period d1 from the point when the main trigger signal is output to the switch SW, which is the switching means of the pulsed power generator 13, until the switching means turns ON.

First, a standby command from the controller 21 of the EUV light source device is transmitted to the evacuation device 17, the initiation raw material supply unit and the motor 20d (steps S101 of Figure 14 and S201 of Figure 15).

Having received the standby command, the evacuation device 17 and the irradiation raw material supply 14 begin operation. That is, the evacuation device 17 operates and a reduced-pressure atmosphere is formed within the chamber 1. Moreover, the motor 20d operates, and the first rotary (discharge) electrode 20a and the second rotary (discharge) electrode 20b rotate. Further, the raw material supply unit 14 for initiation begins supplying raw material initiation material to the second electrode 20b. The operational states described above are collectively called the "standby" state hereafter (steps S102 of Figure 14 and S202 of Figure 15).

The controller 21 of the EUV light source device transmits a standby completion signal to the controller 22 of the lithography tool (steps S103 of Figure 14 and S203 of Figure 15). The controller 21 of the EUV light source device receives a radiation emission command from controller 22 of the lithography tool that has received the standby completion signal. Now, in the event that the intensity of the EUV emission is controlled by the lithography tool, this radiation emission command includes the EUV emission intensity data (steps S104 of Figure 14 and S204 of Figure 15).

The controller 21 of the EUV light source device transmits a charge control signal to the charger CH1 of the pulsed power generator 13. The charge control signal comprises such things as discharge start-up timing signals, for example. In the event that the intensity of the EUV emission is controlled by the controller 22 of the lithography tool, as described above, this charge control signal includes the charging voltage data signals for each of the capacitors C of the PFN circuit area of the pulsed power generator 13.

For example, the relationships between the intensity of EUV emission and the charging voltage of each capacitor C can be determined experimentally beforehand and a table created to hold the relationships between the two. The controller 21 of the EUV light source device, having stored this table, calls up the charging voltage data for each capacitor C of the PFN circuit area from the table, on the basis of the EUV emission intensity data included in the radiation emission command received from the controller 22 of the lithography tool. On the basis of this called data, the controller 21 of the EUV light source device transmits a charge control signal that includes charging voltage data signals for each capacitor C to the charger CH1 of the power supply means (steps S105 of Figure 14 and S205 of Figure 15).

The charger CH1 charges each capacitor C as described above (steps S106 of Figure 14).

The control part 21 of the EUV light source device calculates the timing for transmitting a trigger signal to the laser source 7 based on the timing for outputting a main trigger signal to the switch SW1 of the pulsed power generator 13. The aforementioned timing is decided based on pre-stored time data $\Delta td$ and d1 (Step S107 in Fig. 14 and S206 in Fig. 15).

It is desirable to set the time TL at which the laser beam L1 is irradiated based on a point of time Td at which the switch SW1 of the pulsed power generator 13 turns on after a main trigger signal is input into the switch SW1.

In the present embodiment, a delay time d1 was found between a point of time Td ' at which a main trigger signal was output to the switching means of the pulsed power generator 13 and a point of time Td at which the switching means of the pulsed power generator 13 turned on after the main trigger signal was input into switching means SW1 in advance and then found the point of time Td when the switching means is turned on by correcting the point of time Td' at which a main trigger signal was output to the switching means of the pulsed power generator 13 using the aforementioned delay time d1.

Here, a delay time d2, between a point of time TL' at which a trigger signal is transmitted and a point of time at which a laser beam is irradiated, is disregarded because it is as small as ns order if the laser source is a Q switch type Nd$^+$ - YAG laser.

In short, a point of time TL at which the laser beam L1 is irradiated can be set based on a point of time Td at which the switch SW1 of the pulsed power generator 13 turns on after the main trigger signal is input into the switch SW1 by setting the timing TL' for transmitting the trigger signal to the laser source 7 based on a point of time Td' at which the main trigger signal is output to the switch SW1 of the pulsed power generator 13.

Based on the point of time (Td') at which a main trigger signal is transmitted, the timing TL' for transmitting a trigger signal to the laser source 7 can be found as follows:

As described above, since the laser beam L1 functions as a discharge initiation means (i.e., a laser trigger means), it must commence irradiation at or after a point of time at which the voltage between the electrodes reaches the threshold value Vp. The timing TL at which the laser beam L1 is irradiated is expressed by the following equation based on the point of time Td at which the switching means of the pulsed power generator 13 is turned on.

$$TL \geq Td + \Delta td \qquad (6)$$

Accordingly, based on the point of time Td' at which the main trigger signal is transmitted, the timing TL' for transmitting a trigger signal to the laser source to control the operation of the laser source is expressed as follows:

$$TL' + d2 \geq (Td' + d1) + \Delta td \qquad (7)$$

Here, since a delay time d2 is ignorably small, the timing TL' for transmitting a trigger signal is expressed as follows:

$$TL' \geq Td' + d1 + \Delta td \qquad (8)$$

In the present embodiment, we used the following equation:

$$TL' = Td' + d1 + \Delta td \qquad (9)$$

The point of time at which a laser beam is irradiated can be delayed more than $\Delta td$ in order for the laser beam L1 to be irradiated surely after the voltage between the electrodes exceeds the threshold value Vp. Given that the delay time is $\alpha$, the equation (9) can be modified to the following equation.

$$TL' = Td' + d1 + \Delta td + \alpha \qquad (10)$$

On the other hand, the laser beam L1 also functions as a low temperature plasma gas supply means. In other words, the laser beam L1 needs to irradiate the high temperature plasma material in such a way that at least part of the low temperature plasma gas can selectively reach the narrow discharge channel at a point of time at which the discharge current value reaches the threshold value $I_p$. As described above, the threshold value $I_p$ is set in such a way as to satisfy the following expression, given that the compression pressure by the self-magnetic field of current is $P_B$ and the plasma pressure $P_P$: $P_B \gg P_P$ (the equation (4) above). That is, the current value is such that low temperature plasma gas can sufficiently be compressed by its self-magnetic field.

The aforementioned threshold value $I_P$ is also a current value having energy powerful enough to heat the low temperature plasma gas (in which the ion density is approximately $10^{17}$ to $10^{20}$ cm$^{-3}$ and the electron temperature approximately not more than 1 eV) to 20 to 30 eV or above in electron temperature.

Given that a point of time TL at which a laser beam is irradiated becomes a point of time T1 at which discharge starts and that the time required for the current flowing between the electrodes reaches the threshold value $I_P$ is $\Delta ti$ after the start of discharge, the diameter of the discharge channel flowing in the discharge area is sufficiently narrow at a point of time (T1 + $\Delta ti$).

In order for at least part of the low temperature plasma gas to selectively reach the narrow discharge channel at a time when the discharge current value reaches the threshold value $I_P$, $\Delta tg$ needs to be set in such a way as to satisfy the following expression, given that the period between the point of time at which a laser beam is irradiated to the high temperature plasma material and the point of time at which at least part of the low temperature plasma gas reaches the discharge channel is Δtg.

$$T1 + \Delta ti \le TL + \Delta tg \tag{11}$$

Since T1 = TL,

$$\Delta ti \le \Delta tg \tag{12}$$

In other words, in order to satisfy the above expression, various parameters need to be properly preset, which include the position of the discharge channel and high temperature plasma material 8, the direction of irradiating the laser beam to the high temperature plasma material 8 and the irradiation energy of the laser beam.

In order to make the explanation easier, the aforementioned parameters were properly set in such a way as to satisfy the following equation in the present embodiment.

$$\Delta ti = \Delta tg \tag{13}$$

Here, in order for at least part of the low temperature plasma gas to selectively reach the narrow discharge channel at a time when the discharge current value surely exceeds the threshold value $I_P$, the period between the irradiation of a laser beam and the point of time at which at least part of the low temperature plasma gas selectively reaches the narrow discharge channel may be more or less delayed as compared with the period between the start of discharge and the point of time (T1 + ΔTi) at which the discharge current value reaches the threshold value $I_P$. Given that the delay time is β, the equation (14) can be modified as follows:

$$T1 + \Delta ti + \beta = TL + \Delta tg \tag{15}$$

Since T1 = TL,

$$\Delta ti + \beta = \Delta tg \tag{16}$$

In other words, in order to satisfy the above equation, various parameters are properly preset, which include the position of the discharge channel and high temperature plasma material 8, the direction of the laser beam irradiated to the high temperature plasma material 8 and the irradiation energy of the laser beam.

The control part 21 of the EUV light source device sets a point of time Td' at or after charger charge stability time tst, which is the period required for the charging of each capacitor C to become stable, and transmits a main trigger signal to the switch SW1 of the pulsed power generator 13 at this point of time Td' (Step S 108 in Fig. 14 and S205 and S207 in Fig. 15).

The control part 21 of the EUV light source device transmits a trigger signal to the laser source 7 at the timing TL' set by the Step S108 based on the point of time Td' (Step S109 in Fig. 14 and S210 in Fig. 15).

After a main trigger signal is transmitted in the Step S108 and a delay time d1, from a point of time at which the main trigger signal is input into the switch SW of the pulsed power generator 13 elapses, the switch SW1 (e.g., IGBT) is turned on (S207 and S208 in Fig. 15). Upon the switch SW1 being turned on, the voltage between the first discharge electrode 20a and the second discharge electrode 20b rises. A period Δti later, the voltage between the electrodes reaches the threshold value Vp. As described above, the threshold value Vp is the voltage value when a discharge current value exceeds the threshold value $I_P$ (S208 and S209 in Fig. 15).

In Step S107, as described above, a trigger signal is transmitted to the laser source 7 at the timing TL' based on the equation (9). As a result, the laser beam L 1 irradiates the raw material 8" for initiation supplied to the second electrode 20b and high temperature plasma material 8 at a point of time TL at or after a point of time (Td + Δtd) at which the voltage between the electrodes reaches the threshold value Vp (S210 and S211 in Fig. 15).

After the laser beam irradiates the raw material 8" for initiation, which was supplied to the second electrode 20b, electric discharge occurs and a plasma of the raw material gas for initiation is generated. Then, a narrow discharge channel is formed as the discharge current flowing between the electrodes 20a, 20b increases. As described above, the trigger signal transmission point TL', the laser beam emission point TL and the discharge generation point T1 are regarded as substantially the same point of time. Moreover, in practice, a point of time at which the laser beam L1 irradiates the raw material 8" for initiation and a point of time at which the laser beam L1 irradiates the high temperature plasma material 8 are also regarded as substantially the same as the points of time TL', TL and T1.

At a time when $\Delta ti$ has elapsed after the start of discharge, the discharge current value reaches the aforementioned threshold value $I_P$ (S211 and S212 in Fig. 15).

The laser beam L1 is irradiated to the high temperature plasma material 8 substantially at the same time the laser beam L1 is irradiated to the raw material 8" for initiation. A steady flow of low temperature plasma gas having a good directionality is sprayed out to the narrow discharge channel from the high temperature plasma material 8 irradiated by the laser beam via the high-speed jet nozzle 9b. At least part of the low temperature gas reaches the narrow discharge channel at or after a point of time at which the discharge current value reaches the threshold value $I_P$(T1 +$\Delta ti$) (S212 and S213 in Fig. 15).

As described above, the system is set in such a way that a period $\Delta ti$ required for the current value flowing between the electrodes to reach the threshold value $I_P$ after the start of discharge is equal to a period $\Delta tg$ between the point of time at which a laser beam is irradiated to the high temperature plasma material and the point of time at which at least part of the low temperature plasma gas reaches the discharge channel.

At $\tau_{heat}$ after a point of time (T1 + $\Delta ti$ = T1 + $\Delta tg$), the electron temperature of the low temperature plasma gas reaches 20 to 30 eV to become high temperature plasma, and EUV radiation starts from this high temperature plasma (Step S110 in Fig. 14 and S211 in Fig.15).

Since low temperature plasma gas is continuously supplied to the narrow discharge channel, the pinch effect or the confinement effect by the self-magnetic field of the plasma is repeated. Accordingly, the diameter of the narrow discharge channel is kept in the relatively narrow state though it increases or decreases in a pulsating action. In short, low temperature plasma is repeatedly pinched, and EUV radiation continues.

In the conventional DPP method or LAGDPP method using the pinch effect, the duration of EUV radiation is not longer than 200 ns, for example. Therefore, it is possible to achieve pulse-stretched EUV radiation as compared with the conventional DPP method or LAGDPP method using the pinch effect by setting a discharge circuit composed of a pulsed power generator 13 and a pair of electrodes (i.e., a first electrode 20a and a second electrode 20b) in such a way that the duration of the discharge channel having a current value $I_P$ can last at least (200 ns + $\tau_{heat}$) after the point of time (T1 + $\Delta ti$ = T2 + $\Delta tg$) at which part of the low temperature plasma gas reaches the narrow discharge channel.

The EUV radiation emitted from the high temperature plasma passes through foil trap 16, is collected by grazing incidence type EUV radiation collector optics 4 placed in the radiation collector space and then is guided to the illumination optical system of a lithography tool (not shown here) through an EUV radiation collecting part provided in the chamber 1.

In the EUV generation method according to the present embodiment, as described above, a steady flow of low temperature plasma gas is selectively supplied to a narrow discharge channel generated in a discharge area in advance. As compared with the conventional methods, EUV radiation is obtainable with current of longer pulse width and of a relatively small value flowing in the discharge area.

EUV radiation lasts as long as the relatively narrow discharge channel continues to exist. Accordingly, it is possible to make the duration of the narrow discharge channel longer than that in the conventional methods by forming pulse-stretched discharge current by configuring a discharge circuit in such a way that the discharge current pulses become longer than those in the conventional DPP method or LAGDPP method. As a result, pulse-stretched EUV radiation can be obtained.

The pinch effect or the confinement effect by the self-magnetic field of the low temperature plasma gas can be repeated by setting the system in such a way that at least part of the low temperature plasma gas reaches a discharge channel at or after a point of time at which a discharge current value reaches the threshold value $I_P$. This type of repetition lasts as long as discharge current continues to exist. In the present embodiment, pulse-stretched EUV radiation can be achieved in part because it is possible to set a discharge current pulse to be longer than that in the conventional methods and in part because the continuous pinch effect can be maintained for an extended period of time (i.e., the multi-pinch method). Now, the discharge current threshold value is set to be Ip2, the low temperature plasma gas is heated while being maintained at a level where it does not lose ion density by expanding and becomes a high temperature plasma. This heating of low temperature plasma gas, while maintaining its ion density, is sustained as long as the discharge current continues.

In the present invention, as described above, it is possible to set the discharge current pulse to be longer than that in the conventional methods and maintain the plasma temperature and density required for EUV radiation for an extended period by continuously heating the low temperature plasma, and therefore pulse-stretched EUV radiation can be obtained (i.e., the non-pinch method).

In the present embodiment, since current of a relatively small value can be flown in the discharge area, the thermal load applied to the electrodes can be made small as compared with the conventional methods, resulting in preventing the occurrence of debris. Unlike in the conventional pulse-stretching technology, it is not necessary to deliver high current to the discharge space because the waveform of the plasma current does not need to be controlled in such a way as to keep the high temperature plasma in the pinch state. Neither is there any need to change the waveform of the plasma current in order to maintain the pinch effect, which eliminates any sophisticated synchronization control and current control.

Particularly, in the present embodiment, a laser beam acts as a functional element for a discharge initiation means (i.e., a laser trigger means) and a low temperature plasma supply means. Therefore, it is not necessary to configure a discharge initiation means separately, whereby the system can be downsized.

(2) Embodiment 2

In the embodiment 1, electric discharge was started by irradiating part of the laser beam used for vaporizing high temperature plasma material to the raw material for initiation placed in the second discharge electrode. After the discharge starts, a narrow discharge channel is formed from the raw material for initiation. Subsequently, by setting the system in such a way that at least part of the low temperature plasma gas reaches the discharge channel at or after a point of time at which the discharge current value reaches a specified threshold value, the diameter of the relatively narrow discharge channel is kept within a certain range, which leads to EUV radiation by the multi-pinch method or the non-pinch method.

Here, the amount of gas emitted from the raw material for initiation is small, and the discharge channel formed from the raw material for initiation is a discharge channel formed by vacuum arc discharge. If low temperature plasma gas is selectively supplied to such a discharge channel, the vacuum arc discharge changes into gas discharge. That is, the discharge channel at the time of EUV radiation is a discharge channel by gas discharge. Although it is formed in the vicinity of the position of the raw material for initiation at the second discharge electrode at which it is irradiated by the laser beam, vacuum arc discharge is unstable in terms of its position at the time of the start of discharge. In the multi-pinch method in which EUV radiation is repeatedly generated, the position at which the vacuum arc discharge is generated (i.e., the position of the discharge channel by vacuum arc discharge) fluctuates for each EUV radiation even though the irradiation position of the raw material for initiation with the laser beam is kept constant.

If the position of the discharge channel by vacuum arc discharge fluctuates, the position of the discharge channel by gas discharge also becomes unstable at the time of EUV radiation, resulting in a decline in the stability of EUV radiation. The object of the EUV generation method according to the second embodiment is to solve such a problem.

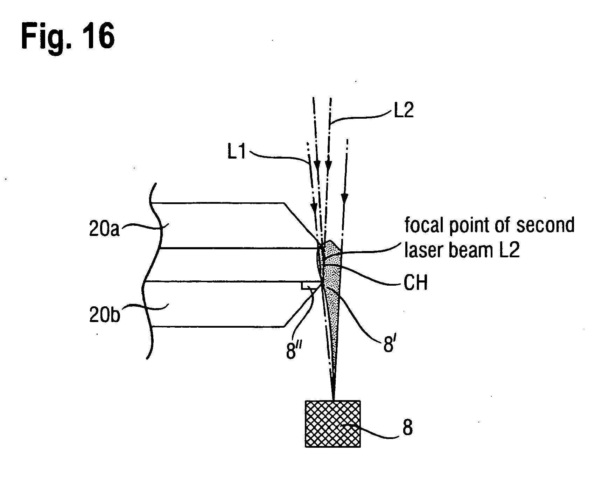

Specifically, as shown in Fig. 16, a second laser beam L2, which is different from the first laser beam L1 used as a laser trigger means, is collected in a specified position in the discharge area immediately after discharge was started by the aforementioned discharge initiation means (i.e., laser trigger means). The aforementioned specified position is in the space between the first discharge electrode 20a and the second discharge electrode 20b, for example, in the vicinity of the position at which part of the first laser beam L1 irradiates the raw material 8" for initiation.

In the neighborhood of the focal point of the second laser beam L2, conductivity is up because of electron emission. Accordingly, the position of the discharge channel CH is fixed in the position at which the focal point of the laser is set. That is, the position of the vacuum arc discharge is demarcated by the second laser beam L2. The positional stability of the originating point of EUV radiation increases as compared with an EUV light source device using the EUV radiation method as shown in Embodiment 1.

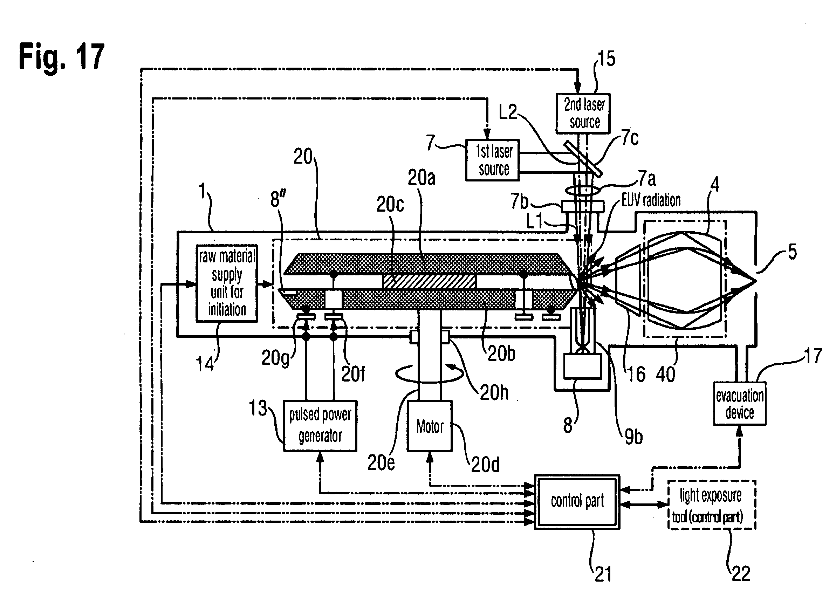

Fig. 17 shows the configuration of Embodiment 2 for an EUV light source device using the method for generating extreme ultraviolet (EUV) radiation according to the present invention. Fig. 17 is the schematic configuration of the aforementioned EUV light source device. EUV radiation is collected on the right side of the drawing.

In the EUV light source device in Fig. 17, a second laser source 15 for emitting a second laser beam L2 for defining the position of the discharge channel at the time of vacuum arc discharge, and a half mirror 7c are added to the EUV light source device in Fig. 12, which uses the EUV generation method according to Embodiment 1. Since the component elements are the same as those in Embodiment 1 except for the irradiation means for the second laser beam, a description only of the irradiation means for the second laser beam L2 is given below.

Here, the laser beam L1 in Embodiment 1 used for irradiating high temperature plasma material is different from the second laser beam L2 used for defining the position of the discharge channel at the time of vacuum arc discharge in Embodiment 2. Accordingly, in order to make the explanation easier, the laser beam used for irradiating high temperature plasma material for vaporization is referred to as a first laser beam L1 in Embodiment 2.

As described above, the first laser beam L1 is used as a common component element for the discharge initiation means (i.e., a laser trigger means) and the low temperature plasma gas supply means. The first laser beam L1 emitted from the first laser source 7a is reflected by the half mirror 7c and incident on high temperature plasma material via a radiation collector means 7a and an entrance window 7b provided for the chamber 1. Here, the first laser beam L1 is aligned in such a way that part of the first laser beam L1 irradiates the raw material 8" for initiation supplied to the second discharge electrode 2b and that the remaining portion of the first laser beam L1 irradiates the high temperature plasma material 8.

The second laser beam L2 used for defining the position of the discharge channel at the time of vacuum arc discharge is emitted from the second laser source 15. The wavelength of the second laser beam L2 is set in the wavelength range that allows it to pass through the aforementioned half mirror 7c. That is, the second laser beam L2 emitted from the second laser source 15 passes through the half mirror 7c and is collected at a specified position in the discharge space via the radiation collector means 7a and the entrance window 7b provided for the chamber 1.

The first laser beam L1, the wavelength of which is set to the reflection wavelength of the half mirror 7c, is reflected by the half mirror 7c that is obliquely placed at 45 degrees. Here, it is possible to provide only one entrance window 7b for the chamber 1 if the incidence direction to the half mirror 7c of the second laser beam L2 set to the transmission wavelength of the half mirror 7c and the reflection direction of the first laser beam L1 are aligned with each other in substantially the same direction.

A Q switch type ND$^+$ - YAG laser device can be used as the first laser source 7 for emitting the first laser beam L1 and the second laser source 15 for emitting the second laser beam L2. Either the wavelength of the first laser beam L1 or the wavelength of the second laser beam L2 is converted by a wavelength conversion element.

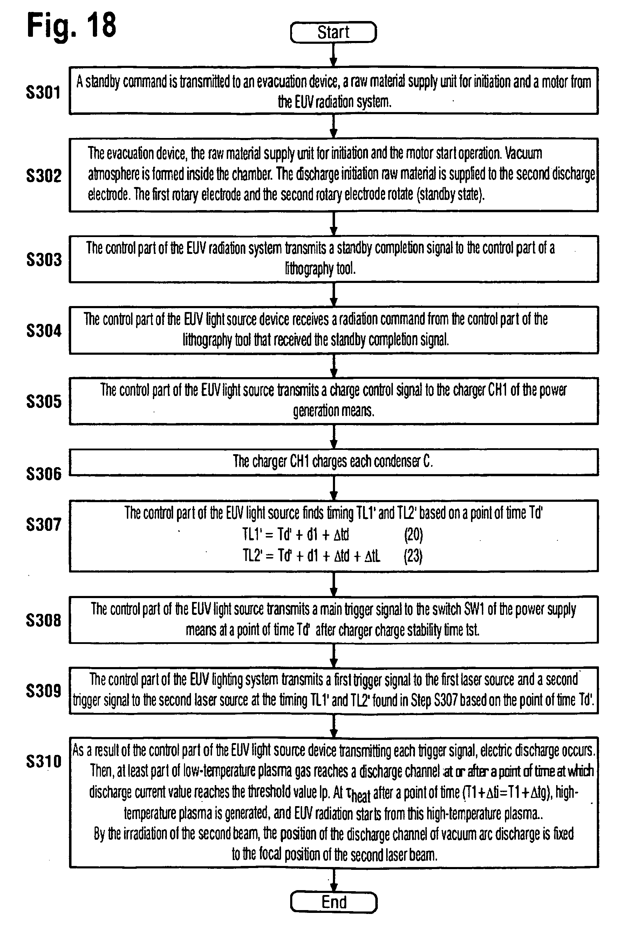

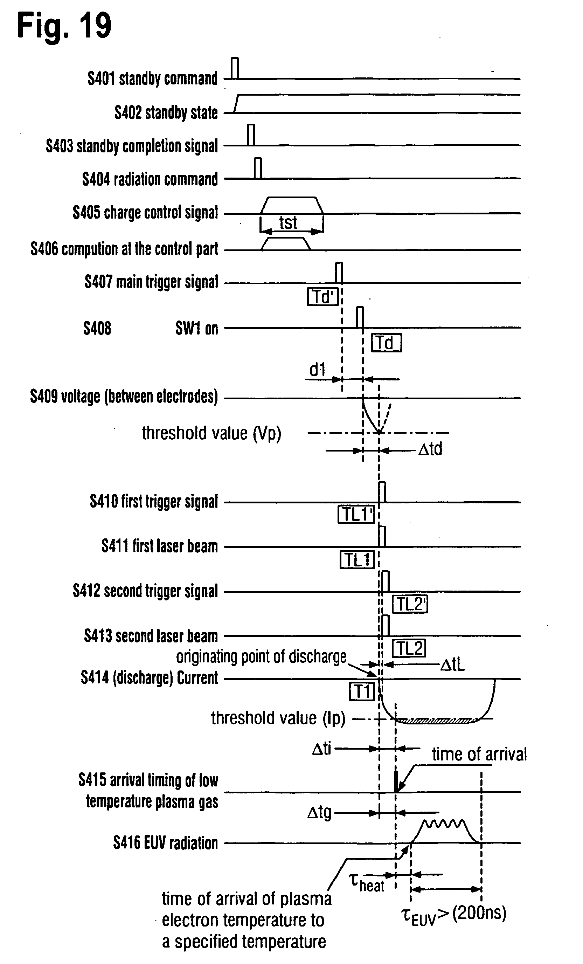

A description of the operation of the aforementioned EUV light source device is given by referring to Figs. 18 & 19. The multi-pinch method is used as an example.

The control part 21 of the EUV light source device stores time data $\Delta td$ and $\Delta tL$, $\Delta td$ being the period between a point of time (time Td) at which a trigger signal is input to the switching means SW1 of the pulsed power generator 13 and the point of time at which the voltage between the electrodes reaches a threshold value V p after the switching means is turned on. On the other hand, $\Delta tL$ is a delay time between the point of time at which the first laser beam is irradiated and the point of time at which the second laser beam is irradiated.

In general, the higher the voltage V applied to the discharge electrodes, the faster the rising of the voltage waveform between discharge electrodes. Accordingly, the aforementioned $\Delta td$ depends on the voltage V applied to discharge electrodes. The control part 21 of the EUV light source device stores data on the relationship between voltage V and time $\Delta td$ found by experiments in advance as a table.

Moreover, the control part 21 stores a delay time d1 between the point of time at which a main trigger signal is output to the switching means SW1 of the pulsed power generator 13 and the point of time at which the switching means is turned on.

First, a standby command is transmitted to the evacuation device 17, the material supply unit for initiation 14 and the motor 20d from the control part 21 of the EUV light source device (step S301 in Fig. 18 and S401 in Fig. 19).

Upon receiving a standby command, the evacuation device 17 and the material supply unit for initiation 14 start operation. That is, the inside of the chamber is evacuated by the operation of the evacuation device 17. Also, by the operation of the motor 20d, the first discharge electrode (rotary electrode) 20a and the second discharge electrode (rotary electrode) 20b start rotating. Moreover, the material supply unit for initiation 14 starts supplying raw material 8" for initiation to the second discharge electrode 20b. The aforementioned operation state is hereinafter referred to as the standby state (Step S302 in Fig. 18 and S402 in Fig. 19).

The control part 21 of the EUV light source device transmits a standby completion signal to the control part 22 of the lithography tool (Step S303 in Fig. 18 and S403 in Fig. 19).

The control part 21 of the EUV light source device receives a radiation command from the control part 22 of the lithography tool that has received the standby completion signal. In the case that the lithography tool controls the intensity of the EUV radiation, the radiation command includes data on the intensity of the EUV radiation (Step S304 in Fig. 18 and S404 in Fig. 19).

The control part 21 of the EUV light source device transmits a charge control signal to the charger CH1 of the power supply means 13. The charge control signal may include a discharge start timing data signal. As described above, if a radiation command from the control part 22 of the lithography tool contains data on the intensity of the EUV radiation, the aforementioned charge control signal includes a charging voltage data signal of each capacitor of the PFN circuit part.

As an example, the relationship between the intensity of the EUV radiation and the charging voltage of each capacitor is found by experiments in advance to make a table for storing data on the relationship. The control part 21 of the EUV light source device stores this table and retrieves charging voltage data of each capacitor of the PFN circuit part from the table based on the data on the intensity of the EUV radiation contained in a radiation command transmitted from the control part 22 of the lithography tool. Based on the charging voltage data thus retrieved, the control part 21 of the EUV light source device transmits a charge control signal, which contains a charging voltage data signal to be transmitted to each capacitor, to the charger CH1 of the pulsed power generator 13 (Step S305 in Fig. 18 and S405 in Fig. 19).

As described above, the charger CH1 charges each capacitor (Step S306 in Fig. 18).

The control part 21 of the EUV light source device calculates the timing for transmitting a first trigger signal to the first laser source 7 based on the timing for outputting a main trigger signal to the switch SW1 of the pulsed power generator 13. The aforementioned timing is decided based on pre-stored time data $\Delta td$ and d1. The control part 21 of the EUV light source device also calculates the timing for transmitting a second trigger signal to the second laser source 15 based on the transmission timing of the first trigger signal thus calculated and pre-stored time data $\Delta tL$ (Step S307 in Fig. 18 and S406 in Fig. 19).

It is desirable to set the time TL1 at which the first laser beam L1 is irradiated based on the point of time Td at which the switch SW1 of the pulsed power generator 13 turns on after the main trigger signal is input into the switch SW1.

In the present embodiment, a delay time d1 between the point of time Td' at which the main trigger signal was output to the switching means of the pulsed power generator 13 and a point of time Td at which the switching means of the pulsed power generator 13 turns on after the main trigger signal was input into the switching means in advance is found, and then, the point of time Td when the switching means is turned on is found by correcting the point of time Td' at which the main trigger signal was output to the switching means of the pulsed power generator 13 using the delay time d1.

Here, a delay time d2, between a point of time TL1' at which the first trigger signal was transmitted and a point of time at which the first laser beam was irradiated, is negligible because it is on a ns order if the first laser source is a Q switch type Nd$^+$ - YAG laser.

In short, the point of time TL1 at which the first laser beam is irradiated can be set based on the point of time Td at which the switch SW1 of the pulsed power generator 13 turns on after the main trigger signal is input into the switch SW1 by setting the timing TL1' for transmitting a trigger signal to the first laser source 7 based on the point of time Td' at which the main trigger signal is output to the switch SW1 of the pulsed power generator 13.

Based on a point of time (Td') at which the main trigger signal is transmitted, the timing TL1' for transmitting a trigger signal to the laser source 7 can be found as follows: As described above, since the first laser beam L1 functions as a discharge initiation means (i.e., a laser trigger means), it must commence irradiation at or after a point of time at which the voltage between the electrodes reaches the threshold value Vp. The timing TL1 at which the first laser beam L1 is irradiated is expressed by the following equation based on a point of time Td at which the switching means of the pulsed power generator 13 is turned on.

$$TL1 \geq Td + \Delta td \dots \qquad (17)$$

Accordingly, based on the point of time Td' at which the main trigger is transmitted, the timing TL1' for transmitting the first trigger signal to the first laser source 7 to control the operation of the first laser source 7 is expressed as follows:

$$TL' + d2 \geq (Td' + d1) + \Delta td \dots \qquad (18).$$

Here, since the delay time d2 is small enough to be ignored, the timing TL1' for transmitting the first trigger signal is expressed as follows:

$$TL1' \geq Td' + d1 + \Delta td \dots \qquad (19).$$

In the present embodiment, the following equation is used:

$$TL1' = Td' + d1 + \Delta td \dots \qquad (20).$$

The point of time at which the first laser beam is irradiated can be delayed by more than $\Delta td$ in order for the first laser beam L1 to be irradiate surely after the voltage between the electrodes exceeds the threshold value Vp. Given that the delay time is $\alpha$, the equation (20) can be modified to the following equation:

$$TL1' = Td' + d1 + \Delta td + \alpha \dots \quad (21).$$

On the other hand, in the present embodiment, the second laser beam is collected in a specified position in the discharge area in order to define the position of the discharge channel by vacuum arc discharge. The aforementioned specified position is in the space between the first discharge electrode 20a and the second discharge electrode 20b, for example, in the vicinity of the position at which part of the first laser beam L1 is irradiated to the raw material 8" for initiation.

Since the second laser beam L2 is used for defining the position of the discharge channel by vacuum arc discharge, the timing TL2 for irradiating the second laser beam L2 needs to be set after electric discharge is started. By contrast, it is difficult to define the position of the discharge channel by irradiating the second laser beam L2 after the current increases subsequent to the start of discharge and the discharge channel is established to a certain degree. In other words, the second laser beam needs to irradiate the aforementioned specified position at a point of time TL2 after electric discharge is started and before the discharge channel is established.

The point of time TL1 at which the first laser beam is emitted is regarded as substantially the same as the point of time T1 at which electric discharge is generated by the first laser beam L1 irradiating the raw material 8" for initiation placed on the electrode 20b. As described above, the delay time d2 between the point of time TL1' at which the first trigger signal is transmitted and the point of time at which the first laser beam L1 is irradiated is small enough to be ignored. Therefore, the first trigger signal transmission point TL1', the first laser beam emission point TL1 and the discharge generation point T1 are substantially the same point of time. Accordingly, a point of time TL2 at which the second laser beam L2 is emitted can be set based on the first trigger signal transmission point TL1'.

Here, the delay time d3, between the point of time TL2' at which the trigger signal is transmitted and the point of time at which the second laser beam L2 is irradiated, is disregard because it is on the order of a ns if the second laser source is a Q switch type $Nd^+$ - YAG laser. In other words, the laser beam emission point TL2 can be set by properly setting the second trigger signal transmission point TL2' based on the first trigger signal transmission point TL1'.

As described above, the control part 21 of the EUV light source device stores a delay time $\Delta tL$ between a point of time at which the first laser beam L1 is irradiated and a point of time at which the second laser beam L2 is irradiated. Thus, the second trigger signal transmission point TL2' is found by the following equation.

$$TL2' = TL1' + \Delta tL \qquad (22)$$

Here, the second trigger signal transmission point TL2' can be found based on the point of time Td' at which the main trigger signal is transmitted by substituting the equation (20) for the equation (22).

$$TL2' = Td' + d1 + \Delta td + \Delta tL \qquad (23)$$

If the system is set in such a way that the first laser beam can be irradiated surely after the voltage between the electrodes exceeds the threshold value Vp, the second trigger signal transmission timing can be found based on the point of time Td' at which the main trigger signal is transmitted by substituting the equation (21) for the equation (22).

$$TL2' = Td' + d1 + \Delta td + \Delta tL + \alpha \qquad (24)$$

By setting the second trigger signal transmission timing TL2 ' in the way as described above, the second laser beam can be collected in the aforementioned specified position at TL2, which is a point of time after discharge is started and before the discharge channel is established. The position of the discharge channel is defined to a position at which the focal point of the laser is set. In other words, the position of vacuum arc discharge is defined by the second laser beam.

The first laser beam L1 also functions as a provider of the low temperature plasma gas. In other words, the first laser beam needs to irradiate the high temperature plasma material in such a way that at least part of the low temperature plasma gas can selectively reach the narrow discharge channel at a point of time at which the discharge current value reaches the threshold value $I_p$.

As described above, the threshold value $I_P$ is set in such a way as to satisfy the following expression, given that the compression pressure produced by the self-magnetic field of the current is $P_B$ and plasma pressure $P_P$: $P_B \gg P_P$ (the equation (4) above). That is, a current value is such that low temperature plasma gas can sufficiently be compressed by its self-magnetic field.

The aforementioned threshold value $I_P$ is also a current value having energy powerful enough to heat the low temperature plasma gas (in which ion density is approximately $10^{17}$ to $10^{20}$ cm$^{-3}$ and electron temperature approximately at most 1 eV) to 20 to 30 eV or above in electron temperature.

Given that a point of time TL1 at which the first laser beam commences irradiation becomes the point of time T1 at which discharge starts and that the time required for the current flowing between the electrodes reaches the threshold value $I_P$ is $\Delta ti$ after the start of discharge, the diameter of the discharge channel flowing in the discharge area is sufficiently narrow at a point of time (T1 + Δti).

In order for at least part of the low temperature plasma gas to selectively reach the narrow discharge channel at a time when the discharge current value reaches the threshold value $I_P$, Δtg needs to be set in such a way as to satisfy the following expression, given that the period between the point of time at which the first laser beam starts to irradiate the high temperature plasma material and the point of time at which at least part of the low temperature plasma gas reaches the discharge channel is Δtg.

$$T1 + \Delta ti \leq TL1 + \Delta tg \qquad (25)$$

Since T1 = TL1,

$$\Delta ti \leq \Delta tg \qquad (26).$$

In other words, in order to satisfy the above expression, various parameters need to be properly preset, which include the position of the discharge channel and high temperature plasma material 8, the direction of the first laser beam toward the high temperature plasma material 8 and the irradiation energy of the first laser beam.
In order to make the explanation easier, the aforementioned parameters were properly set in such a way as to satisfy the following equation in the present embodiment.

$$\Delta ti = \Delta tg \qquad (27).$$

Here, in order for at least part of the low temperature plasma gas to selectively reach the narrow discharge channel at a time when the discharge current value surely exceeds the threshold value $I_P$, the period between the irradiation of the first laser beam and the point of time at which at least part of the low temperature plasma gas selectively reaches the narrow discharge channel may be more or less delayed as compared with the period between the start of discharge and the point of time (T1 + ΔTi) at which the discharge current value reaches the threshold value $I_P$. Given that the delay time is β, the equation (22) can be modified as follows:

$$T1 + \Delta ti + \beta = TL1 + \Delta tg \qquad (28)$$

Since T1 = TL1,

$$\Delta ti + \beta = \Delta tg \qquad (29).$$

In other words, in order to satisfy the above equation, various parameters are properly preset, which include the position of the discharge channel and high temperature plasma material 8, the direction of laser beam toward the high temperature plasma material 8 and the irradiation energy of the laser beam.

The control part 21 of the EUV light source device sets a point of time Td' at or after charger charge stability time tst, which is the period required for the charging of each capacitor C to become stable, and transmits a main trigger signal to the switch SW1 of the high voltage generation means at the point of time Td' (Step S308 in Fig. 18 and S405 and S407 in Fig. 19).

The control part 21 of the EUV light source device transmits the first trigger signal to the laser source at the timing TL1' set by the Step S307 based on the point of time Td'. It also transmits the second trigger signal to the second laser source 15 at the timing TL2' based on the point of time Td' (Step S309 in Fig. 18 and S410 and S412 in Fig. 19).

After the main trigger signal is transmitted in the Step S308 and a delay time d1, from a point of time at which the main trigger signal is input into the switch SW1 of the pulsed power generator 13, elapses, the switch SW1 (e.g., IGBT) is turned on (S407 and S408 in Fig. 19).

Upon the switch SW1 being turned on, the voltage between the first rotary electrode 20a and the second rotary electrode 20b rises. A period $\Delta$td later, the voltage between the electrodes reaches the threshold value Vp. As described above, the threshold value Vp is the voltage value when the discharge current value exceeds the threshold value $I_P$ (S408 and S409 in Fig. 19).

In the Step S309, as described above, the first trigger signal is transmitted to the first laser source at the timing TL1' based on the equation (20). As a result, the first laser beam irradiates the raw material 8" for initiation supplied to the second electrode and high temperature plasma material 8 at a point of time TL1 at or after a point of time (Td + $\Delta$td) at which the voltage between the electrodes reaches the threshold value Vp (S410 and S411 in Fig. 19).

After the laser beam irradiates the raw material 8" for initiation, which was supplied to the second electrode 20b, electric discharge occurs and plasma of initiation raw material gas is generated. Then, a narrow discharge channel is formed as discharge current flowing between the electrodes increases.

As described above, the first trigger signal transmission point TL1', the first laser beam emission point TL1 and the discharge generation point T1 are regarded as substantially the same point of time. Moreover, in practice, the point of time at which the laser beam L1 irradiates the raw material 8" for initiation and the point of time at which the first laser beam L1 irradiates the high temperature plasma material 8 are also regarded as substantially the same as the points of time TL', TL and T1.

In the Step S309, as described above, the second trigger signal is transmitted to the second laser source 15 at the time TL2' based on the equation (23). As a result, the second laser beam L2 is collected in the aforementioned specified position at time TL2, which is the point of time after the point of time T1 at which discharge is started and before the point of time at which the discharge channel is established. The position of the discharge channel is defined to a position at which the focal point of laser is set. In other words, the position of vacuum arc discharge is defined by the second laser beam L2 (S412 and S413 in Fig. 19).

At a time when $\Delta$ti has elapsed after the start of discharge, the discharge current value reaches the aforementioned threshold value $I_P$ (S411 and S414 in Fig. 19).

The first laser beam L1 irradiates the high temperature plasma material 8 substantially at the same time as the first laser beam L1 irradiates the raw material 8" for initiation. A steady flow of low temperature plasma gas having a good directionality is sprayed out to the narrow discharge channel from the high temperature plasma material 8 irradiated by the first laser beam L1 via the high-speed jet nozzle. At least part of the low temperature gas reaches the narrow discharge channel at or after a point of time at which the discharge current value reaches the threshold value $I_P$(T1 + $\Delta$ti) (S414 and S415 in Fig. 19).

As described above, the system is set in such a way that the period $\Delta$ti required for a current value flowing between the electrodes to reach the threshold value $I_P$ after the start of discharge is equal to a period $\Delta$tg between the point of time at which the laser beam L1 irradiates the high temperature plasma material and the point of time at which at least part of the low temperature plasma gas reaches the discharge channel.

At $\tau_{heat}$ after a point of time (T1 + $\Delta$ti = T1 + $\Delta$tg), the electron temperature of low temperature plasma gas reaches 20 to 30 eV to become high temperature plasma, and EUV radiation starts from this high temperature plasma (Step S310 in Fig. 18 and S416 in Fig.19).

Since low temperature plasma gas is continuously supplied to the narrow discharge channel, the pinch effect or the confinement effect by its self-magnetic field is repeated. Accordingly, the diameter of the narrow discharge channel is kept in the relatively narrow state though it increases or decreases in a pulsating action. In short, low temperature plasma is repeatedly pinched, and EUV radiation continues.

In the conventional DPP method or LAGDPP method using the pinch effect, the duration of EUV radiation is at most 200 ns, for example. Therefore, with the present invention, it is possible to achieve pulse-stretched EUV radiation as compared with the conventional DPP method or LAGDPP method using the pinch effect by setting the discharge circuit composed of a pulsed power generator 13 and a pair of electrodes (i.e., a first electrode and a second electrode) in such a way that the duration of the discharge channel having a current value $I_P$ can last at least (200 ns + $\tau_{heat}$) after the point of time (T1 + $\Delta$ti = T2 + $\Delta$tg) at which part of the low temperature plasma gas reaches the narrow discharge channel.

The EUV radiation emitted from the high temperature plasma passes through the foil trap 16, is collected by grazing incidence type EUV radiation collector optics 4 placed in the radiation collection space and then is guided to the illumination optical system of a lithography tool (not shown here) through an EUV radiation extracting part 5 provided in the chamber 1.

Like the EUV generation method as shown in Embodiment 1, the EUV generation method according to the present embodiment allows pulse-stretched EUV radiation to be obtained by either the multi-pinch method or the non-pinch method.

Moreover, thermal loads applied to the electrodes can be made small compared with the conventional methods, which leads to the prevention of the occurrence of debris. Also, unlike the conventional long pulsing technology, it is not necessary to flow high current in the discharge space or change the waveform of the discharge current in order to maintain the pinch effect. In other words, any sophisticated current control is not required.

Specifically, in the present embodiment, the second laser beam L2, which is different from the first laser beam L1, is collected in a specified position in the discharge area. The aforementioned specified position is in the space between the first discharge electrode 20a and the second discharge electrode 20b, for example, in the vicinity of a position at which part of the first laser beam L1 irradiates the raw material 8" for initiation.

Accordingly, the position of the discharge channel of the vacuum arc discharge can be fixed to a position at which the focal point of laser is set. In other words, by defining the position of the vacuum arc discharge by the second laser beam L2, the position of the originating point of the EUV radiation can further be stabilized as compared with an EUV light source device using the EUV radiation method according to Embodiment 1.

It is desirable that the pulse width of the second laser beam L2 used for defining the position of the discharge channel of gas discharge is more or less short. If the pulse width of the second laser beam L2 is short, the peak power of the second laser beam becomes large. That is, ion drift becomes small in the area where the second laser beam L2 is collected, and the degree of ionization becomes large. Accordingly, the diameter of the discharge channel becomes narrower, and the discharge channel has a clear boundary. The pulse width is preferably not larger than 1 ns.

## Claims

1. A method of generating extreme ultraviolet radiation comprising the steps of:

    vaporizing raw material and producing raw material gas by irradiating the raw material with an energy beam outside of a discharge area,
    forming a discharge path in the discharge area,
    generating high temperature plasma by adding energy to the raw material gas by means of an electric discharge, and
    generating extreme ultraviolet radiation from said high temperature plasma,
    the method being **characterized in that**, after said discharge path is formed, raw material gas is continuously supplied to said discharge path, thereby setting the duration time of the discharge path to not less than 1 μsec.

2. The method of generating extreme ultraviolet radiation according to claim 1, wherein an energy beam irradiates said discharge path to fix the position of said discharge path.

3. The method of generating extreme ultraviolet radiation according to claim 2, wherein the gas supplied to said discharge path has an ion density that is substantially equivalent to an ion density under the conditions of emitting extreme ultraviolet radiation which is $10^{17}$ cm$^{-3}$ to $10^{20}$ cm$^{-3}$ and wherein said gas is heated by electric discharge to a temperature sufficient to generate extreme ultraviolet radiation which is 20 eV to 30 eV or higher in order to continuously generate extreme ultraviolet radiation for at least 200 ns.

4. The method of generating extreme ultraviolet radiation according to claim 1, wherein the gas supplied to said discharge path has an ion density that is substantially equivalent to an ion density under the conditions of emitting extreme ultraviolet radiation which is $10^{17}$ cm$^{-3}$ to $10^{20}$ cm$^{-3}$ and wherein said gas is heated by electric discharge to a temperature sufficient to generate extreme ultraviolet radiation which is 20 eV to 30 eV or higher in order to continuously generate extreme ultraviolet radiation for at least 200 ns.

5. The method of generating extreme ultraviolet radiation according to claim 4, wherein said discharge is generated by supplying a current pulse between the electrodes and wherein said gas is supplied to said discharge channel in a steady flow with good directionality by means of a flow control mechanism.

6. The method of generating extreme ultraviolet radiation according to claim 1, wherein said discharge is generated by supplying a current pulse between to electrodes and wherein said gas is supplied to said discharge channel in a steady flow with good directionality by means of a flow control mechanism.

7. The method of generating extreme ultraviolet radiation according to claim 6, wherein said energy beam is a laser beam.

8. The method of generating extreme ultraviolet radiation according to claim 1, wherein said energy beam is a laser beam.

9. An extreme ultraviolet light source device comprising;

a container (1);
a pair of electrodes (20a, 20b) provided inside said container (1) at a specified spacing from each other;
a pulsed power generator (13) for supplying pulses to said electrodes (20a, 20b);
a raw material supply means (8) that is suitable for continuously supplying vaporized raw material gas for emitting extreme ultraviolet radiation to a discharge path after said discharge path has been formed between said electrodes (20a, 20b),
a radiation collector means (4) for collecting extreme ultraviolet radiation emitted from high temperature plasma generated at the discharge path; and
an extreme ultraviolet radiation extraction part (5) for extracting the collected extreme ultraviolet radiation,
wherein said pulsed power generator (13) is suitable for forming said discharge path by means of pulsed power of a duration of at least 1 $\mu$s between said electrodes, and wherein said raw material supply means (8) comprises an energy beam irradiation means (7) for vaporizing said raw material by irradiating the raw material located in a space outside said discharge path in such a way that vaporized raw material can reach said discharge path in order to supply raw material gas, the ion density of which is substantially equivalent to that under conditions for emitting extreme ultraviolet radiation which is $10^{17}$ cm$^{-3}$ to $10^{20}$ cm$^{-3}$, to said discharge path.

10. The extreme ultraviolet light source device according to claim 9, further comprising a second energy beam irradiation means (15) for generating a second energy beam directed to said discharge path and for fixing the position said discharge path by said second energy beam.

11. The extreme ultraviolet light source device according to claim 10, further comprising a supply means (14) for supplying a raw material for initiation of a discharge to one of the electrodes where discharge is to be generated in advance of producing a discharge with the vaporized raw material.

12. The extreme ultraviolet light source device according to claim 9, further comprising a supply means (14) for supplying a raw material for initiation of a discharge to one of the electrodes where discharge is to be generated in advance of producing a discharge with the vaporized raw material.

13. The extreme ultraviolet light source device according to claim 12, wherein said energy beam is a laser beam (L1).

14. The extreme ultraviolet light source device according to claim 9, wherein said energy beam is a laser beam (L1).

15. The extreme ultraviolet light source device according to claim 10, wherein said energy beam and said second energy beam are laser beams (L1, L2).

**Patentansprüche**

1. Verfahren zum Erzeugen von Extremultraviolettstrahlung, umfassend die Schritte:

   Verdampfen von Rohstoff und Erzeugen von Rohstoffgas durch die Bestrahlung des Rohstoffes mit einem Energiestrahl außerhalb des Entladungsbereichs,
   Bildung eines Entladungswegs im Entladungsbereich,
   Erzeugen von Hochtemperaturplasma, indem mittels einer elektrischen Entladung dem Rohstoffgas Energie hinzugefügt wird, und
   Erzeugen von Extremultraviolettstrahlung aus dem Hochtemperaturplasma,
   **dadurch gekennzeichnet, dass** nach Bildung des Entladungswegs dem Entladungsweg ununterbrochen Rohstoffgas zugeführt wird, wodurch die Dauer des Entladungswegs auf nicht weniger als 1$\mu$s eingestellt wird.

2. Verfahren zum Erzeugen von Extremultraviolettstrahlung gemäß Anspruch 1, wobei ein Energiestrahl den Entladungsweg bestrahlt, um die Position des Entladungsweges zu bestimmen.

3. Verfahren zum Erzeugen von Extremultraviolettstrahlung gemäß Anspruch 2, wobei das dem Entladungsweg zugeführte Rohstoffgas eine Ionendichte aufweist, die im Wesentlichen einer Ionendichte unter den Bedingungen einer Emission von Extremultraviolettstrahlung entspricht, welche $10^{17}$ cm$^{-3}$ bis $10^{20}$ cm$^{-3}$ beträgt, und wobei das Gas durch elektrische Entladung auf eine ausreichende Temperatur erhitzt wird, um Extremultraviolettstrahlung zu erzeugen, die 20 eV bis 30 eV oder höher ist, um für mindestens 200 ns ununterbrochen Extremultraviolettstrahlung zu erzeugen.

**4.** Verfahren zum Erzeugen von Extremultraviolettstrahlung gemäß Anspruch 1, wobei das dem Entladungsweg zugeführte Rohstoffgas eine Ionendichte aufweist, die im Wesentlichen einer Ionendichte unter den Bedingungen einer Emission von Extremultraviolettstrahlung entspricht, welche $10^{17}$ cm$^{-3}$ bis $10^{20}$ cm$^{-3}$ beträgt, und wobei das Gas durch elektrische Entladung auf eine ausreichende Temperatur erhitzt wird, um Extremultraviolettstrahlung zu erzeugen, die 20 eV bis 30 eV oder höher ist, um für mindestens 200 ns ununterbrochen Extremultraviolettstrahlung zu erzeugen.

**5.** Verfahren zum Erzeugen von Extremultraviolettstrahlung gemäß Anspruch 4, wobei die Entladung **dadurch** erzeugt wird, dass zwischen den Elektroden ein Stromimpuls zugeführt wird, und wobei mittels eines Flusskontrollmechanismus das Gas in einem konstanten Fluss mit guter Ausrichtung dem Entladungskanal zugeführt wird.

**6.** Verfahren zum Erzeugen von Extremultraviolettstrahlung gemäß Anspruch 1, wobei die Entladung **dadurch** erzeugt wird, dass zwischen den Elektroden ein Stromimpuls zugeführt wird, und wobei mittels eines Flusskontrollmechanismus das Gas in einem konstanten Fluss mit guter Ausrichtung dem Entladungskanal zugeführt wird.

**7.** Verfahren zum Erzeugen von Extremultraviolettstrahlung gemäß Anspruch 6, wobei der Energiestrahl ein Laserstrahl ist.

**8.** Verfahren zum Erzeugen von Extremultraviolettstrahlung gemäß Anspruch 1, wobei der Energiestrahl ein Laserstrahl ist.

**9.** Eine Extremultraviolettlichtquellevorrichtung, umfassend
einen Behälter (1);
ein Paar Elektroden (20a, 20b), welche innerhalb des Behälters (1) in einem bestimmten Abstand voneinander angebracht sind;
ein Impulsstromerzeuger (13) zum Zuführen von Impulsen zu den Elektroden (20a, 20b),
ein Rohstoffzufuhrmittel (8), welches dazu geeignet ist, nach Bildung des Entladungswegs zwischen den Elektroden (20a, 20b) dem Entladungsweg verdampftes Rohstoffgas für die Emission von Extremultraviolettstrahlung ununterbrochen zuzuführen,
ein Strahlungskollektormittel (4) zum Sammeln von Extremultraviolettstrahlung, welche vom am Entladungsweg erzeugten Hochtemperaturplasma emittiert wird; und
ein Extremultraviolettstrahlungextraktionsteil (5) zum Entnehmen von gesammelter Extremultraviolettstrahlung, wobei der Impulsstromerzeuger (13) dazu geeignet ist, mittels eines Impulsstroms von einer Dauer von mindestens 1 μs zwischen den Elektroden den Entladungsweg zu bilden, und wobei das Rohstoffzufuhrmittel (8) ein Energiestrahlbestrahlungsmittel (7) umfasst zum Verdampfen des Rohstoffes durch die Bestrahlung des in einem Raum außerhalb des Entladungsweges befindlichen Rohmaterials derart, dass verdampfter Rohstoff den Entladungsweg erreichen kann, um dem Entladungsweg Rohstoffgas zuzuführen, dessen Ionendichte im Wesentlichen der Ionendichte unter den Bedingungen einer Emission von Extremultraviolettstrahlung entspricht, welche $10^{17}$ cm$^{-3}$ bis $10^{20}$ cm$^{-3}$ beträgt.

**10.** Die Extremultraviolettlichtquellevorrichtung gemäß Anspruch 9, weiter umfassend ein zweites Energiestrahlbestrahlungsmittel (15) zum Erzeugen eines zweiten auf den Entladungsweg gerichteten Energiestrahls und zur Bestimmung der Position des Entladungsweges durch den zweiten Energiestrahl.

**11.** Die Extremultraviolettlichtquellevorrichtung gemäß Anspruch 10, weiter umfassend ein Zufuhrmittel (14) zum Zuführen eines Rohmaterials für die Einleitung einer Entladung zu einem der Elektroden, wo die Entladung erzeugt werden soll, bevor eine Entladung mit dem verdampften Rohstoff erzeugt wird.

**12.** Die Extremultraviolettlichtquellevorrichtung gemäß Anspruch 9, weiter umfassend ein Zufuhrmittel (14) zum Zuführen eines Rohmaterials für die Einleitung einer Entladung zu einem der Elektroden, wo die Entladung erzeugt werden soll, bevor eine Entladung mit dem verdampften Rohstoff erzeugt wird.

**13.** Die Extremultraviolettlichtquellevorrichtung gemäß Anspruch 12, wobei der Energiestrahl ein Laserstrahl (L1) ist.

**14.** Die Extremultraviolettlichtquellevorrichtung gemäß Anspruch 9, wobei der Energiestrahl ein Laserstrahl (L1) ist.

**15.** Die Extremultraviolettlichtquellevorrichtung gemäß Anspruch 10, wobei der Energiestrahl und der zweite Energiestrahl Laserstrahlen (L1, L2) sind.

**Revendications**

1. Méthode pour générer un rayonnement extrême ultraviolet comprenant les étapes:

vaporisation de la matière brute et production de gaz de matière brute par l'irradiation de la matière brute avec un rayon d'énergie en dehors de la zone de décharge,
formation d'un chemin de décharge dans la zone de décharge,
génération de plasma à haute température par l'addition d'énergie au gaz de matière brute par le biais d'une décharge électrique, et
génération de rayonnement extrême ultraviolet dudit plasma à haute température,
**caractérisée en ce que**, après la formation du chemin de décharge, ledit chemin de décharge est alimenté en gaz de matière brute de façon continue, ainsi réglant le temps de durée du chemin de décharge à non moins de 1$\mu$s.

2. Méthode pour générer un rayonnement extrême ultraviolet selon la revendication 1, dans laquelle un rayon d'énergie irradie ledit chemin de décharge afin de fixer la position dudit chemin de décharge.

3. Méthode pour générer un rayonnement extrême ultraviolet selon la revendication 2, dans laquelle le gaz fourni audit chemin de décharge a une densité ionique qui est essentiellement équivalente à une densité ionique dans les conditions de l'émission de rayonnement extrême ultraviolet, qui est $10^{17}$ cm$^{-3}$ à $10^{20}$ cm$^{-3}$, et dans laquelle ledit gaz est réchauffé par décharge électrique à une température suffisante pour générer un rayonnement extrême ultraviolet qui est 20 eV à 30 eV ou plus élevé afin de générer de façon continue un rayonnement extrême ultraviolet pendant au moins 200 ns.

4. Méthode pour générer un rayonnement extrême ultraviolet selon la revendication 1, dans laquelle le gaz fourni audit chemin de décharge a une densité ionique qui est essentiellement équivalente à une densité ionique dans les conditions de l'émission de rayonnement extrême ultraviolet, qui est $10^{17}$ cm$^{-3}$ à $10^{20}$ cm$^{-3}$, et dans laquelle ledit gaz est réchauffé par décharge électrique à une température suffisante pour générer un rayonnement extrême ultraviolet qui est 20 eV à 30 eV ou plus élevé afin de générer de façon continue un rayonnement extrême ultraviolet pendant au moins 200 ns.

5. Méthode pour générer un rayonnement extrême ultraviolet selon la revendication 4, dans laquelle ladite décharge est générée en fournissant une impulsion de courant entre les électrodes et dans laquelle ledit gaz est fourni audit canal de décharge dans un flux constant avec une bonne directivité par le biais d'un mécanisme de contrôle de flux.

6. Méthode pour générer un rayonnement extrême ultraviolet selon la revendication 1, dans laquelle ladite décharge est générée en fournissant une impulsion de courant entre les électrodes et dans laquelle ledit gaz est fourni audit canal de décharge dans un flux constant avec une bonne directivité par le biais d'un mécanisme de contrôle de flux.

7. Méthode pour générer un rayonnement extrême ultraviolet selon la revendication 6, dans laquelle ledit rayon d'énergie est un faisceau laser.

8. Méthode pour générer un rayonnement extrême ultraviolet selon la revendication 1, dans laquelle ledit rayon d'énergie est un faisceau laser.

9. Dispositif de source de lumière extrême ultraviolette comprenant:

un récipient (1);
une paire d'électrodes (20a, 20b) disposée en dedans dudit récipient (1) à une distance spécifiée l'une de l'autre;
un générateur d'énergie d'impulsions (13) pour fournir des impulsions auxdites électrodes (20a, 20b);
un moyen d'alimentation en matière brute (8) qui est apte à alimenter de façon continue le chemin de décharge en gaz de matière brute vaporisé pour émettre un rayonnement extrême ultraviolet après la formation du chemin de décharge entre lesdites électrodes (20a, 20b),
un moyen de collecteur de rayonnement (4) pour collecter un rayonnement extrême ultraviolet émis du plasma à haute température généré au chemin de décharge; et
une partie d'extraction de rayonnement extrême ultraviolet (5) pour extraire le rayonnement extrême ultraviolet collecté,
dans lequel ledit générateur d'énergie à impulsions (13) est apte pour former ledit chemin de décharge par le biais d'une énergie à impulsions d'une durée d'au moins 1μs entre lesdites électrodes, et

dans lequel le moyen d'alimentation en matière brute (8) comprend un moyen d'irradiation à rayons d'énergie (7) pour vaporiser ladite matière brute en irradiant la matière brute qui est dans un espace en dehors dudit chemin de décharge de telle façon que la matière brute vaporisée puisse atteindre ledit chemin de décharge afin d'alimenter ledit chemin de décharge en gaz de matière brute dont la densité ionique est essentiellement équivalente à celle dans des conditions pour émettre un rayonnement extrême ultraviolet, qui est $10^{17}$ cm$^{-3}$ à $10^{20}$ cm$^{-3}$.

10. Dispositif de source de lumière extrême ultraviolette selon la revendication 9, en outre comprenant un second moyen d'irradiation à rayons d'énergie (15) pour générer un second rayon d'énergie dirigé audit chemin de décharge et pour fixer la position dudit chemin de décharge par ledit second rayon d'énergie.

11. Dispositif de source de lumière extrême ultraviolette selon la revendication 10, en outre comprenant un moyen d'alimentation (14) pour alimenter une des électrodes où la décharge est à générer en matière brute pour l'initiation d'une décharge avant la génération d'une décharge avec la matière brute vaporisée.

12. Dispositif de source de lumière extrême ultraviolette selon la revendication 9, en outre comprenant un moyen d'alimentation (14) pour alimenter une des électrodes où la décharge est à générer en matière brute pour l'initiation d'une décharge avant la génération d'une décharge avec la matière brute vaporisée.

13. Dispositif de source de lumière extrême ultraviolette selon la revendication 12, dans lequel ledit rayon d'énergie est un faisceau laser (L1).

14. Dispositif de source de lumière extrême ultraviolette selon la revendication 9, dans lequel ledit rayon d'énergie est un faisceau laser (L1).

15. Dispositif de source de lumière extrême ultraviolette selon la revendication 10, dans lequel ledit rayon d'énergie et ledit second rayon d'énergie sont des faisceaux laser (L1; L2).

# Fig. 1

# Fig. 2 (a) Plasma current

threshold value Ip

# Fig. 2 (b) Radius of low temperature plasma

Gas injection

Electron temperature reaches a specified value by heating.

# Fig. 2 (c) EUV radiation

EUV radiation

# Fig. 3 (a) Plasma current

threshold value Ip2

# Fig. 3 (b) Radius of low temperature plasma

Gas injection

Electron temperature reaches a specified value by heating.

# Fig. 3 (c) EUV radiation

EUV radiation

# Fig. 4

Fig. 5 (a)   triggering source (PFN)

Fig. 5 (b)   voltage (between electrodes)

Fig. 5 (c)   (discharge) current

Fig. 5 (d)   laser beam

Fig. 5 (e)   EUV radiation

# Fig. 6 (a)

# Fig. 6 (b)

# Fig. 7 (a)

# Fig. 7 (b)

# Fig. 7 (c)

# Fig. 8

# Fig. 9 (a)

L1
8
8a

# Fig. 9 (b)

L1
8
8a

# Fig. 10 (a)

# Fig. 10 (b)

## Fig. 11 (a)

high-temperature plasma

2a

8

8'

L1

4

EUV radiation

optical axis

## Fig. 11 (b)

10

2a

high-temperature plasma

8

L1

8'

2b

4

EUV radiation

optical axis

# Fig. 12

EP 2 046 100 B1

# Fig. 13

PFN circuit part

13

# Fig. 14

```
Start
```

**S101** A standby command is transmitted to an evacuation device, a raw material supply unit for initiation and a motor from the EUV radiation system.

**S102** The evacuation device, the raw material supply unit for initiation and the motor start operation. Vacuum atmosphere is formed inside the chamber. The discharge initiation raw material is supplied to the second discharge electrode. The first rotary electrode and the second rotary electrode rotate (standby state).

**S103** The control part of the EUV radiation system transmits a standby completion signal to the control part of a lithography tool.

**S104** The control part of the EUV light source device receives a radiation command from the control part of the lithography tool that received the standby completion signal.

**S105** The control part of the EUV light source transmits a charge control signal to the charger CH1 of the power generation means.

**S106** The charger CH1 charges each condenser C.

**S107** The control part of the EUV light source finds timing TL' based on a point of time Td'

$$TL' = Td' + d1 + \Delta td \qquad (9)$$

**S108** The control part of the EUV light source transmits a main trigger signal to the switch SW1 of the power supply means at a point of time Td' at or after charger charge stability time tst.

**S109** The control part of the EUV light source transmits a trigger signal to the laser source at the timing TL' found in Step S107 based on the point of time Td'.

**S110** As a result of the control part of the EUV light source device transmitting each trigger signal, electric discharge occurs. Then, at least part of low-temperature plasma gas reaches a discharge channel after a point of time at which a discharge current value reaches the threshold value Ip. At $\tau_{heat}$ at or after a point of time (Tl + $\Delta$ti = Tl + $\Delta$tg), high-temperature plasma is generated, and EUV radiation starts from this high-temperature plasma.

```
End
```

# Fig. 15

S201 standby command

S202 standby state

S203 standby completion signal

S204 radiation signal

S205 charge control signal — tst

S206 compution at the control part

S207 main trigger signal — Td'

S208 SW1 on — Td

d1

S209 voltage (between electrodes)

threshold value (Vp) — Δtd

S210 trigger signal — TL'

S211 laser beam — TL

originating point of discharge

S212 (discharge) current — T1

threshold value (Ip)

Δti time of arrival

S213 arrival timing of low temperature plasma gas — Δtg

S214 EUV radiation

$\tau_{heat}$

time of arrival of plasma electron temperature to a specified temperature

$\tau_{EUV} > (200ns)$

# Fig. 16

L2

L1

20a

focal point of second
laser beam L2

CH

20b

8''

8'

8

# Fig. 17

# Fig. 18

```
Start
```

**S301** A standby command is transmitted to an evacuation device, a raw material supply unit for initiation and a motor from the EUV radiation system.

**S302** The evacuation device, the raw material supply unit for initiation and the motor start operation. Vacuum atmosphere is formed inside the chamber. The discharge initiation raw material is supplied to the second discharge electrode. The first rotary electrode and the second rotary electrode rotate (standby state).

**S303** The control part of the EUV radiation system transmits a standby completion signal to the control part of a lithography tool.

**S304** The control part of the EUV light source device receives a radiation command from the control part of the lithography tool that received the standby completion signal.

**S305** The control part of the EUV light source transmits a charge control signal to the charger CH1 of the power generation means.

**S306** The charger CH1 charges each condenser C.

**S307** The control part of the EUV light source finds timing TL1' and TL2' based on a point of time Td'

$$TL1' = Td' + d1 + \Delta td \qquad (20)$$
$$TL2' = Td' + d1 + \Delta td + \Delta tL \qquad (23)$$

**S308** The control part of the EUV light source transmits a main trigger signal to the switch SW1 of the power supply means at a point of time Td' after charger charge stability time tst.

**S309** The control part of the EUV lighting system transmits a first trigger signal to the first laser source and a second trigger signal to the second laser source at the timing TL1' and TL2' found in Step S307 based on the point of time Td'.

**S310** As a result of the control part of the EUV light source device transmitting each trigger signal, electric discharge occurs. Then, at least part of low-temperature plasma gas reaches a discharge channel at or after a point of time at which discharge current value reaches the threshold value Ip. At $\tau_{heat}$ after a point of time $(T1 + \Delta ti = T1 + \Delta tg)$, high-temperature plasma is generated, and EUV radiation starts from this high-temperature plasma..
By the irradiation of the second beam, the position of the discharge channel of vacuum arc discharge is fixed to the focal position of the second laser beam.

```
End
```

# Fig. 19

S401 standby command

S402 standby state

S403 standby completion signal

S404 radiation command

S405 charge control signal
tst

S406 compution at the control part

S407 main trigger signal
Td'

S408 SW1 on
Td

d1

S409 voltage (between electrodes)

threshold value (Vp)
Δtd

S410 first trigger signal
TL1'

S411 first laser beam
TL1

S412 second trigger signal
TL2'

S413 second laser beam
TL2

originating point of discharge
ΔtL

S414 (discharge) Current
T1

threshold value (Ip)

Δti

time of arrival

S415 arrival timing of low
temperature plasma gas

Δtg

S416 EUV radiation

$\tau_{heat}$

time of arrival of plasma
electron temperature to
a specified temperature

$\tau_{EUV} > (200ns)$

# Fig. 20

# Fig. 21 (a) Plasma current
(Prior Art)

# Fig. 21 (b) Plasma radius
(Prior Art)

Period A

# Fig. 21 (c) EUV light
(Prior Art)

Plasma pinch

# Fig. 22 (a) Plasma current
(Prior Art)

Heating current
waveform section (M)

Containing current
waveform section (N)

# Fig. 22 (b) Plasma radius
(Prior Art)

Period B

# Fig. 22 (c) EUV light
(Prior Art)

EUV
light

Plasma pinch

# Fig. 23
## (Prior Art)

main controller — 21

light exposure unit (control part) — 22

from gas exhaust port →

12

3

2a

1a

2c

2b

1b

to material supply/ evacuation unit

C2

C1

D2

D1

CH

L2

L1

SW2

SW1

A2

A1

11

4

5

1

6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007515741 A
- US 2008116400 A
- WO 2005004555 A1
- JP 2007505460 A
- US 20070090304 A1
- WO 2005101924 A1
- WO 2006120942 A1
- JP 2007123138 A
- WO 2005060321 A
- JP 6325708 A
- WO 2006101942 A1
- WO 2006120942 A
- US 2007090304 A
- US 6359969 B

### Non-patent literature cited in the description

- Status and Prospects of Research on EUV (Extreme Ultraviolet) Light Sources for Lithography. *J. Plasma Fusion Res.,* March 2003, vol. 79 (3), 219-260